(19) Europäisches Patentamt
European Patent Office
Office européen des brevets

(11) **EP 4 661 266 A1**

# (12) EUROPEAN PATENT APPLICATION

(43) Date of publication:
**10.12.2025 Bulletin 2025/50**

(21) Application number: **25315186.4**

(22) Date of filing: **26.05.2025**

(51) International Patent Classification (IPC):
**H02M 1/00** $^{(2006.01)}$       **H02M 3/158** $^{(2006.01)}$
**H02M 3/157** $^{(2006.01)}$

(52) Cooperative Patent Classification (CPC):
**H02M 3/1588; H02M 1/0009; H02M 3/157**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.06.2024 IT 202400012970**

(71) Applicant: **STMicroelectronics International N.V.
1228 Plan-les-Ouates, Geneva (CH)**

(72) Inventors:
• **Poletto, Vanni
20151 MILANO (IT)**

• **Bianchi, Simone
15122 ALESSANDRIA (IT)**
• **Signini, Matteo
27100 PAVIA (IT)**
• **Brera, Marco
20145 MILANO (IT)**
• **Pavlin, Antoine
13540 PUYRICARD (FR)**

(74) Representative: **Buzzi, Notaro & Antonielli d'Oulx
S.p.A.
Corso Vittorio Emanuele II, 6
10123 Torino (IT)**

## (54) CURRENT ESTIMATION OR SENSING METHODS

(57)    A high-side switch ($Q_1$) comprises a high-side control terminal configured to receive a high-side control signal (DRV1) as well as a current flow path therethrough between the high-side reference node ($V_{IN}$) and the switching node (SW), the high-side switch ($Q_1$) being configured to be made conductive in response to the high-side control signal (DRV1) having a first logic value during a first time interval ($HS_{ON}$). A low-side switch ($Q_2$) comprises a low-side control terminal configured to receive a low-side control signal (PWM, DRV2) as well as a current flow path therethrough between the switching node (SW) and the low-side reference node (PGND), the low-side switch ($Q_2$) being configured to be made conductive in response to the low-side control signal (DRV2) having said first logic value during a second time interval ($LS_{ON}$). The method comprises coupling an inductive element (L) to the switching node (SW) and to an output node (Vout) configured to be coupled to a load (30), and providing a sensed switching voltage ($V_{SW}$) to a filter circuit (42) configured to provide a filtered voltage (Vo_est) based on said sensed switching voltage ($V_{SW}$), the filtered voltage (Vo_est) indicative of the output voltage at said output node (Vout). Based on a difference ($V_{IND}$) between said filtered voltage (Vo_est) and said sensed switching voltage ($V_{SW}$), the method provides (43, 44, 46) to user circuitry (48) an output current signal (IHS_est, ISENSE) indicative of the intensity of a current through the inductive load (L) during an estimation time ($\Delta T_{EST}$) equal to or greater than said first time interval ($HS_{ON}$).

FIG. 4

**Description**

Technical field

The description relates to current estimation and sensing methods.
For instance, one or more embodiments may be applied in sensing a current flowing through an inductive load in an electronic device, such as, e.g., a switched (or switching) converter.
One or more embodiments may be used in applications where, as is the case in the automotive field, for instance, preserving accuracy in operation over the lifetime of an electronic device is a desirable feature.

Background

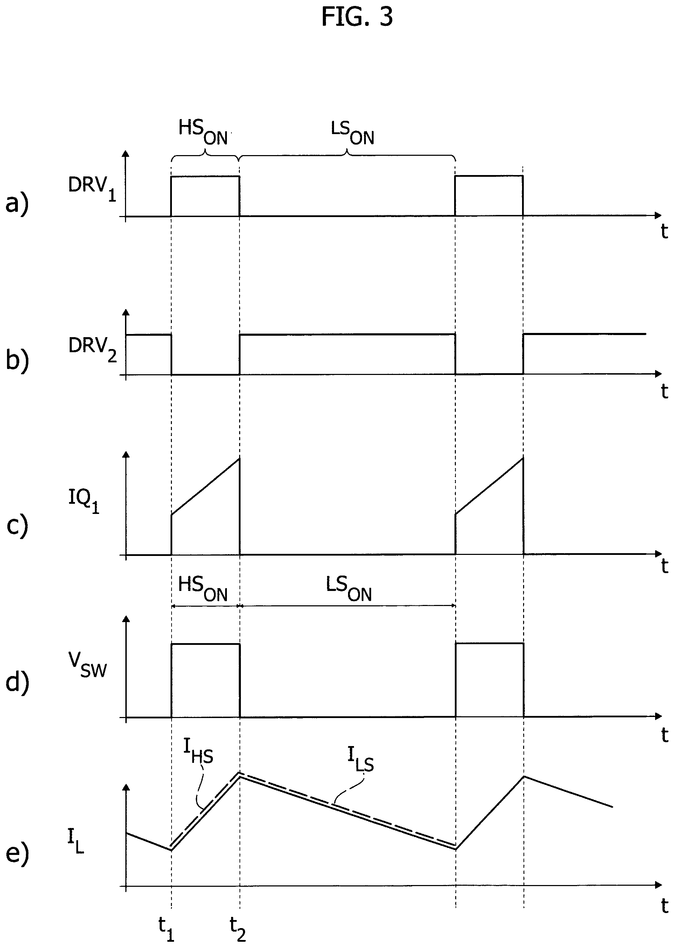

A pair of power switches in a so-called half-bridge arrangement may be configured to drive electromechanical loads in either one of two configurations: a High-Side Driver (briefly, HSD) configuration in which the load is connected between an output node of the half-bridge and a ground line, and a Low-Side Driver configuration (briefly, LSD) in which the load is connected between a voltage supply line and the output node of the half-bridge.
Power-supply circuits, such as AC/DC or DC/DC switched mode power supplies, are well known in the art. There exist many types of electronic converters, which are mainly divided into isolated and non-isolated converters. For instance, non-isolated electronic converters are the converters of the "buck", "boost", "buck-boost", "Ćuk", "SEPIC", and "ZETA" type. Instead, isolated converters are, for instance, converters of the "flyback", "forward", "half-bridge", and "full-bridge" type. Such types of converters are well known to the person skilled in the art.

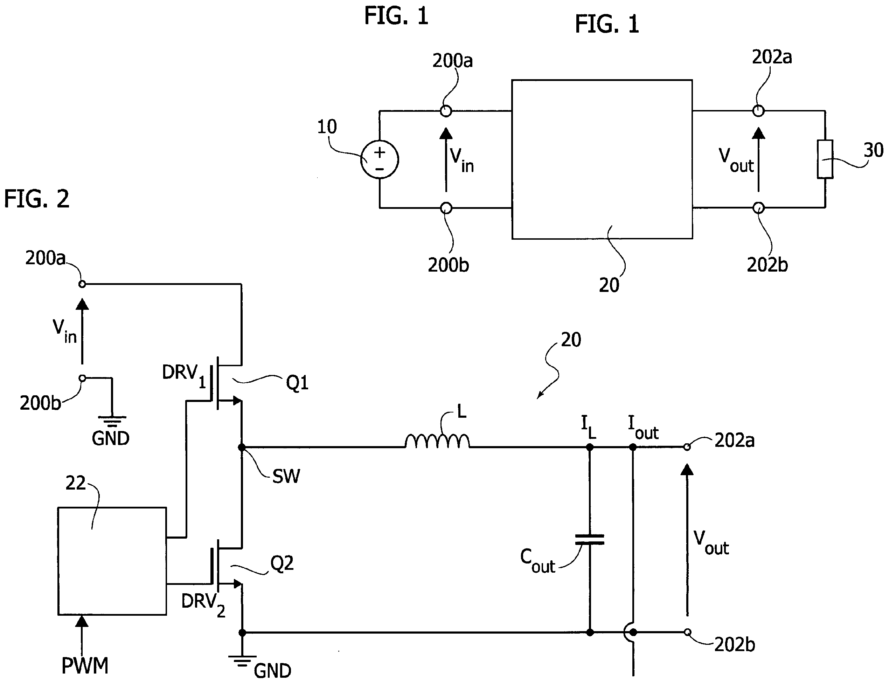

Figure 1 is a schematic illustration of a DC/DC electronic converter 20. In particular, a conventional electronic converter 20 comprises two input terminals 200a and 200b for receiving a DC voltage Vin and two output terminals 202a and 202b for supplying a DC voltage Vout. For example, the input voltage Vin may be supplied by a DC voltage source 10, such as a battery, or may be obtained from an AC voltage by means of a rectifier circuit, such as a bridge rectifier, and possibly a filtering circuit. Instead, the output voltage Vout may be used to supply a load 30.
Voltage converters of a non-isolated step-down type are widely used, for example, in order to supply microcontrollers. The ease of use, simplicity, and excellent versatility in the various conditions of input and output voltage render the topology of a buck type one of the most widely used for this type of conversion.
Figure 2 shows the circuit diagram of a typical buck converter 20. In particular, a buck converter 20 comprises two input terminals 200a and 200b for receiving a DC input voltage Vin and two output terminals 202a and 202b for supplying a regulated voltage Vout, where the output voltage is equal to or lower than the input voltage Vin.
In particular, typically, a buck converter 20 comprises two electronic switches Q1 and Q2 (with the current path thereof) connected (e.g. directly) in series between the input terminals 200a and 200b, wherein the intermediate node between the electronic switches Q1 and Q2 represents a switching node SW. Specifically, the electronic switch Q1 is a high-side switch connected (e.g. directly) between the (positive) terminal 200a and the switching node SW, and the electronic switch Q2 is a low-side switch connected (e.g. directly) between the switching node SW and the (negative) terminal 200b, which often represents a ground GND. The (high-side) switch Q1 and the (low-side) switch Q2 hence represent a half-bridge configured to connect the switching node SW to the terminal 200a (voltage Vin) or the terminal 200b (ground GND).
For example, the switches Q1 and/or Q2 are often transistors, such as Field-Effect Transistors (FETs), such as Metal-Oxide-Semiconductor Field-Effect Transistors (MOSFETs), e.g. n-channel FET, such as NMOS. Frequently, the second electronic switch Q2 is also implemented just with a diode, where the anode is connected to the terminal 200b and the cathode is connected to the switching node SW.
In the example considered, an inductance L, such as an inductor, is connected (e.g. directly) between the switching node SW and the (positive) output terminal 202a. Instead, the (negative) output terminal 202b is connected (e.g. directly) to the (negative) input terminal 200b.
In the example considered, to stabilise the output voltage Vout, the converter 20 typically comprises a capacitor Cout connected (e.g., directly) between the output terminals 202a and 202b.
As exemplified in Figure 2, the operation of the circuit 20 is driven by a controller circuit block 22 that can comprise an input node to receive a common pulsed-width modulation, PWM signal, and an amplifier circuitry to provide respective control signals DRV1, DRV2 to the first and second switches Q1, Q2.
In this context, Figure 3 shows some waveforms of the signals of such an electronic converter, where:

- Figure 3a shows the signal DRV1 for switching the electronic switch Q1;
- Figure 3b shows the signal DRV2 for switching the second electronic switch Q2;
- Figure 3c shows the current IQ1 that traverses the electronic switch Q1;
- Figure 3d shows the voltage signal $V_{SW}$ at the switching node SW (i.e., the voltage at the second switch Q2); and

- Figure 3e shows the current $I_L$ that traverses the inductor L.

In particular, when the electronic switch Q1 is closed at an instant t1 (ON state), the current $I_L$ in the inductor L increase (substantially) linearly. The electronic switch Q2 is at the same time opened (OFF state). Instead, when the electronic switch Q1 is opened (turned off) after an interval $HS_{ON}$ at an instant t2 (OFF state), the electronic switch Q2 is closed (turned ON), and the current $I_L$ decreases (substantially) linearly. Finally, the switch Q1 is closed again after an interval $LS_{ON}$. In the example considered, the switch Q2 (or a similar diode) is hence closed when the switch Q1 is open, and vice versa.

The current in the inductor $I_L$ can thus be used to charge the capacitor Cout, which supplies the voltage Vout at the terminals 202a and 202b. In the example considered, to stabilize the output voltage Vout, the converter 20 typically comprises a capacitor Cout connected (e.g., directly) between the output terminals 202a and 202b.

As exemplified in Figure 3e, the evolution over time of the current $I_L$ flowing in the inductor L is equal to the current flowing in the first switch Q1 during the first time interval $HS_{ON}$ and equal to the current flowing in the second switch Q2 during the second time interval $LS_{ON}$.

DC/DC buck converters as exemplified in Figure 1 comprise a half-bridge (HB) power stage Q1, Q2 for transferring electrical energy between an input voltage level Vin and an output voltage level Vout. For instance, input voltage level Vin can be about 12 Volts while output voltage level Vout can be about 1.2 Volts. For instance, the load current intensity $I_L$ can reach values of about 50 Amperes.

Efficient power supply management is relevant for modern microprocessors, since faster processors use lower supply voltages (e.g., down to 1.2 V) because of thinner gate oxides and higher currents (e.g., even up to 200 Amperes).

One of the most important parameters in a buck converter is the load regulation, which is the capability of the circuit to keep the output voltage Vout stable in response to changing load conditions, which also implies a varying output current $I_{out}$. When the output current $I_{out}$ changes over time, overshoots and undershoots can be observed in the output voltage Vout as a function of the ratio $\pm \Delta I_{out}/\Delta T$, wherein $\Delta I_{out}$ represents the variation of the current $I_{out}$ in a given time interval $\Delta T$. In fact, when the output current $I_{out}$ changes, the current $I_L$ supplied by the inductor L may be too high or too low, thereby creating a variation of the voltage Vout at the capacitor Cout.

In a manner per se known, the buck converter exemplified in Figures 1 and 2 may be used to supply a microcontroller, which may also be configured to drive other loads. These microprocessors may be equipped on-board vehicles. Therefore, current sensing for monitoring the state of power supply stages may be relevant for safety standards.

Existing solutions for sensing the current $I_L$ flowing in the inductive load L involve the use of a shunt resistor in series with the inductance L. In the application context considered, such an option is in contrast with reducing power dissipation.

Other known solutions are based on measuring the current flowing in the inductive load L as the sum of currents flowing in the HS and LS transistors during the respective time in which they are turned ON (that is, they are closed). In this case, any known method may be used to provide the two separate measurements. Nevertheless, the reliability of such current sensing method varies with the duty cycle, becoming less reliable for short duty cycle values (e.g., a value of duty cycle about 0.1 causes a HS conduction time as short as 100 ns for a typical switching frequency of 1 MHz, where 1 ns = 1 nanosecond = $10^{-9}$ seconds). Therefore, the measurement of the current flowing in the HS becomes challenging, even if the LS conduction time (e.g., 0.9 microseconds) remains sufficiently long for accurate current measurement of the low-side current component.

Other existing solutions involve:

- proving a pin VOS to perform a measurement of the output voltage Vout, thereby providing the possibility of performing an indirect measurement of high-side current;
- providing a pin LSET for setting an inductive load value, thereby providing a way to obtain an indirect measurement of high-side current by relying on a precise inductor value.

Document US 2010/0060257 A1 discusses a technique for determining an output current of a power converter circuit that samples a voltage of a switch node voltage signal at a midpoint of a low phase of the switch node voltage signal and generates a sensed current signal at least partially based on the sampled switch node voltage and a calibration voltage. In at least one embodiment of the invention, an apparatus includes a current sensing circuit configured to generate a sensed current signal indicative of an average output current of a power converter circuit. The sensed current signal is at least partially based on a sample of a voltage signal on a first node of the power converter circuit. The first node is used to supply a current to an inductor of the power converter circuit.

Document US20210159788A1 discusses a current estimation circuit configured to estimate current within a power switch, e.g., within a switching voltage converter, using a voltage measured across its load terminals and its on-state resistance. Ringing and other transient anomalies associated with a turn-on transition of the power switch are neglected by ignoring the measured voltage across the power switch for a blanking interval after the transition. During the remainder of the conduction interval of the power switch, the measured voltage is sampled to provide first and second samples. Also, during this interval, a slope of the measured voltage is estimated and tracked. The estimated slope and the first and second samples are combined to produce an estimate of the current for the entire conduction interval of the power switch, including the blanked interval. The estimated slope is used to correct for inaccuracy introduced by not using measured voltage during the blanking interval.

Object and summary

An object of one or more embodiments is to adequately address the issues discussed in the foregoing.

According to one or more embodiments, that object can be achieved via a method having the features set forth in the claims that follow.

One or more embodiments may relate to a corresponding circuit.

One or more embodiments may relate to a corresponding electronic converter device.

One or more embodiments may relate to a corresponding processing or control unit.

One or more embodiments may be equipped on board e vehicle.

One or more embodiments may relate to a corresponding current measurement method.

The claims are an integral part of the technical teaching provided herein with reference to the embodiments.

One or more embodiments facilitate providing an estimate of the current flow in a high side transistor of a half-bridge arrangement based on the flow of current sensed in the low-side transistor during the time in which the latter is turned on.

One or more embodiments facilitate providing an accurate reading without introducing any shunt resistance, thereby improving energy efficiency of the power stage.

One or more embodiments use relatively simple means with respect to known solutions involving discrete power MOS transistors for current sensing.

Brief description of the several views of the drawings

One or more embodiments will now be described, by way of non-limiting example only, with reference to the annexed Figures, wherein:

- Figure 1 shows a typical application of an electronic converter;
- Figure 2 shows an example of a buck converter;
- Figure 3 shows exemplary waveforms of the converter of Figure 2;
- Figure 4 is a diagram exemplary of one or more embodiments as per the present disclosure;
- Figure 5 is a diagram exemplary of an evolution over time of signals in one or more embodiments as per the present disclosure;
- Figure 6 is a diagram exemplary of principles underlying one or more embodiments;
- Figure 7 is a diagram exemplary of principles underlying one or more embodiments;
- Figure 8 is a diagram exemplary of principles underlying one or more embodiments;
- Figure 9 is a diagram exemplary of one or more embodiments as per the present disclosure;
- Figure 10 is a diagram exemplary of an evolution over time of signals in one or more embodiments as per the present disclosure;
- Figure 11 is a diagram exemplary of principles underlying one or more embodiments;
- Figure 12 is a diagram exemplary of one or more embodiments as per the present disclosure;
- Figure 13 is a diagram exemplary of an evolution over time of signals in one or more embodiments as per the present disclosure;
- Figure 14 is a diagram of extrapolated signals in one or more embodiments as per the present disclosure;
- Figure 15 is a diagram of an evolution over time of signals in one or more embodiments as per the present disclosure;
- Figure 16 is a diagram exemplary of a sensing circuit according to one or more embodiments;
- Figure 17 is a diagram exemplary of a portion of the circuit exemplified in Figure 16;
- Figure 18 is a diagram exemplary of an electronic device equipped with the circuit as per the present disclosure;
- Figure 19 is a diagram exemplary of an electronic system equipped with the circuit as per the present disclosure;
- Figure 20 is a diagram exemplary of a vehicle equipped with the circuit as per the present disclosure, and
- Figures 21 and 22 are diagrams exemplary of working principles underlying one or more embodiments.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The references used herein are provided merely for convenience and hence do not define the extent of protection or the scope of the embodiments.

For the sake of simplicity, in the following detailed description a same reference symbol may be used to designate both a node/line in a circuit and a signal which may occur at that node or line.

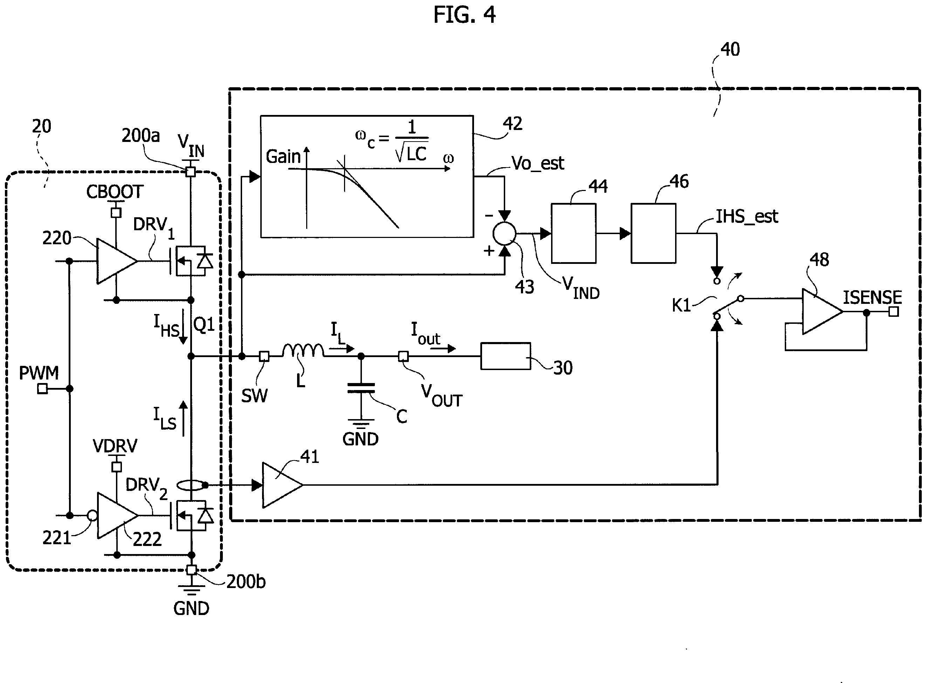

As exemplified in Figure 4, the electronic converter circuit 20 comprises:

a control node PWM configured to receive the pulsed width modulation signal to drive the first Q1 and second Q2 switches of the half-bridge arrangement of switches;
a first amplifier circuit 220 coupled to the control node PWM and configured to provide the first drive signal DRV1 to the first switch Q1, to control operation thereof in a manner per se known, and
a second amplifier circuit 222 coupled to the control node PWM via an inverter circuit 221 and configured to provide the second drive signal DRV2 to the second switch Q2, to control operation thereof in a manner per se known.

As exemplified in Figure 4, the electronic converter circuit 20 is coupled to a current sensing circuit 40.

According to the present disclosure, the current sensing circuit 40 comprises:

a first current amplifier circuit 41 intermediate the switching node SW of the converter 20 and the second switch Q2 and configured to sense a current $I_{LS}$ flowing in the current flow path through the second switch Q2 while it is turned on or closed, namely during at least one portion of the second time interval $LS_{ON}$;
a current estimation cascade of circuit blocks 42, 44, 46 coupled to the switching node SW of the converter 20 and comprising current estimation circuitry configured to estimate the value of the current flowing in the first switch Q1, and
a selector element K1, such as a switch, configured to be turned on or off based on a timing signal K1, the selector element K1 coupled to a current sense amplifier 48 configured to provide the value of the current flowing in the inductive element L coupled to the converter circuit 20.

It is noted that the value of the inductive element L is in principle not necessarily known to the current sensing circuit 40.

In one or more embodiments, the current sensing amplifier 41 may be per se known. In a manner per se known, the sensing signal provided by the amplifier 41 may be a voltage sensing signal having a certain relation with the low-side current $I_{LS}$. For instance, the relation may be expressed as $5mV/A \cdot I_{LS}$.

As exemplified in Figure 4, the current estimation cascade 42, 44, 46 comprises:

an output voltage estimator circuit block 42 configured to provide an estimated voltage Vo_est indicative of the output voltage Vout at the output of the converter 20;
a superposition circuit 43 coupled to the switching node SW and to the output voltage estimator circuit block 42 to provide an estimated voltage drop Vind across inductive element L as a difference between the voltage $V_{SW}$ at the switching node SW and the estimated output voltage Vo_est;
an inductance estimator circuit block 44 coupled to the superposition circuit 43 and configured to provide an estimate of an inverse 1/L of the inductance of the inductive element L;
an integrator circuit block 46 coupled to the inductance estimator circuit block 44 and configured to compute a ratio of the estimated voltage drop Vind and the inverse inductance 1/L, providing an estimated inductive current intensity IHS_est as a result.

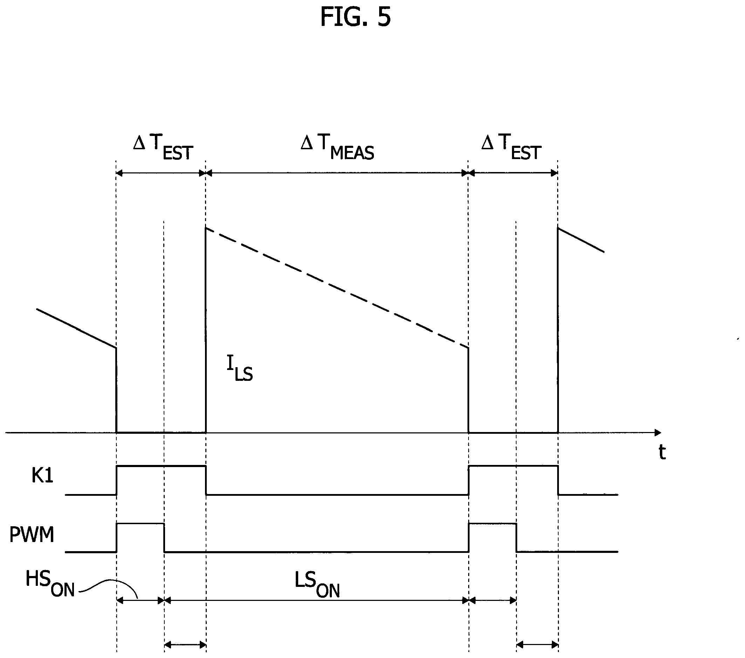

As exemplified in Figure 5, the selector circuit K1 is configured to provide the measured sensing current $I_{LS}$ through the second switch Q2 during a sensing time interval $\Delta T_{MEAS}$ and to provide the estimated inductive current intensity IHS_est during an estimation time interval $\Delta T_{EST}$.

As illustrated in Figure 5, at the beginning of the second time interval $LS_{ON}$, the current sense amplifier transitions from turned-off to turned-on, hence it may not be ready to provide the current measurement. Thereby, the estimation time interval K1 can be greater than the on-time $HS_{ON}$ of the first switch Q1. For instance, the estimation time interval K1 may be equal to the sum of the first on-time interval $HS_{ON}$ and of a settling time interval for the current sense amplifier to yield the measurement result. For instance, the settling time may be about 200 ns (1 ns = 1 nanosecond = $10^{-9}$ seconds).

As exemplified herein, the output voltage estimator circuit block 42 comprises a filter circuit having a cut-off angular frequency $\omega_C$ that is indicative of the actual cut-off frequency of the LC circuit coupled to the switching node SW. For instance, a $2^{nd}$ order low pass filter, known per se, may be exploited for the output voltage estimator circuit block 42 in one or more embodiments. For instance, the cut-off frequency $f_c$ of the output voltage estimator circuit block 42 may be set in a range of 15kHz to 17kHz, preferably 16.0 kHz (1kHz = 1 kiloHertz = $10^3$ Hertz) considering conventional values for inductance L of about 0.15 microHenry and capacitance C of about 660 microFarad.

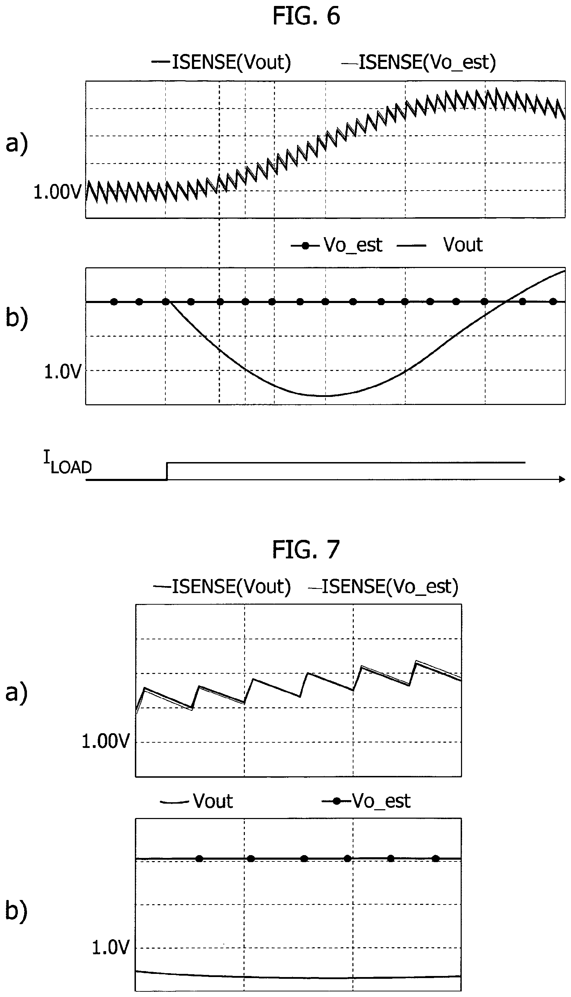

As exemplified in Figure 6, even if there are few differences among the values of the estimated output voltage Vo_est and the actual output voltage Vout, as reported in portion b) of Figure 6, the estimated current ISENSE(Vo_est) has value close to the actual ones ISENSE(Vout), as reported in portion a) of Figure 6.

Figure 7 is an enlarged view of the dashed rectangular portion of the diagrams exemplified in Figure 6. As illustrated in Figure 7, portion b) presents a comparison of estimated Vo_est and actual Vout output voltage signals and portion a) presents a comparison of the output voltage ISENSE of the buffer 48 based on the estimated ISENSE(Vo_est) or actual ISENSE(Vout) which in both cases reaches output current values about 20 Amperes and constant on-time during a time interval of 4 microseconds.

As exemplified in Figure 4, the output signal ISENSE may be indicative of the current flowing in the inductive load L thanks to a relationship (per se known) that may be expressed as: $ISENSE = 5mV/A \cdot I_L$

As exemplified herein, the inductance estimator circuit block 44 comprises an automatic gain control (AGC) loop whose gain is indicative of the inductance value 1/L and whose value is continually refreshed at every PWM cycle.

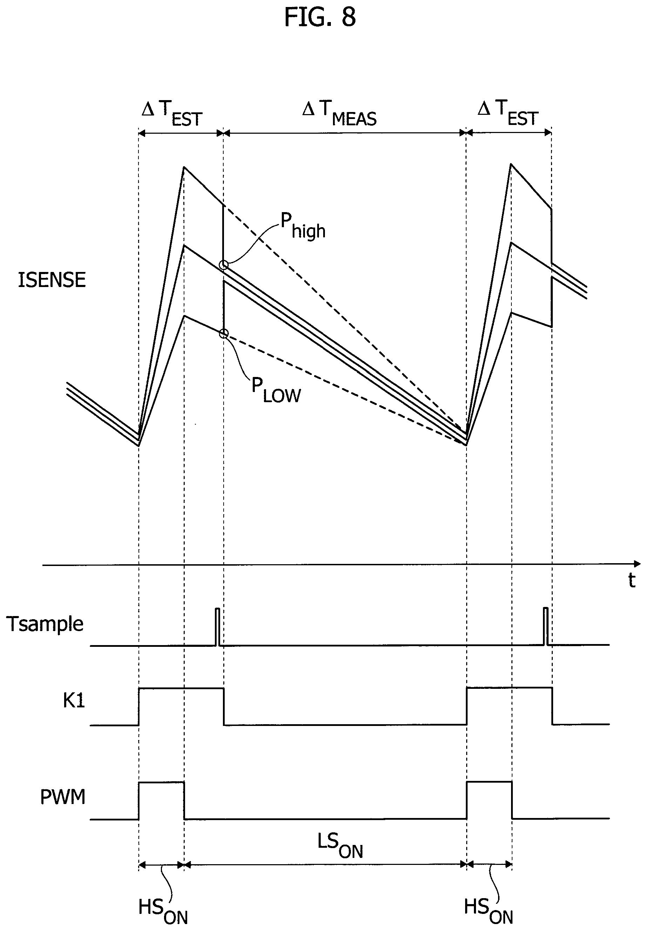

Figure 8 is exemplary of principles underlying operation of the circuit block 44.

As exemplified in Figure 8, the AGC starts from an initially approximated gain value (for example, after power up) and it can take several PWM cycles (e.g., 100 cycles) for settling a stationary gain value. For instance, the AGC is partially digital, and it can retain the gain value in digital volatile memory for as long as the power supply is up.

As exemplified in Figure 8:

the AGC loop samples the value of the output current sensing signal ISENSE in the time interval in which the selector circuit K1 is closed while the first switch Q1 is open, specifically very close to the time in which the selector K1 is switched, obtaining an initial estimate L0;
in case the initial estimate L0 is too low with respect to the actual inductance value L, the output ISENSE of the buffer 48 presents a vertical drop Phigh in the current values; therefore, the AGC loop decreases the gain;
in case the initial estimate L0 is too high with respect to the actual inductance value L, the output ISENSE of the buffer 48 presents a vertical increase Plow in the current values; therefore, the AGC loop increases the gain;
the process above is iterated until a comparison between the output sensing signal ISENSE before and after the sampling time Tsample of the AGC loop can be considered negligible.

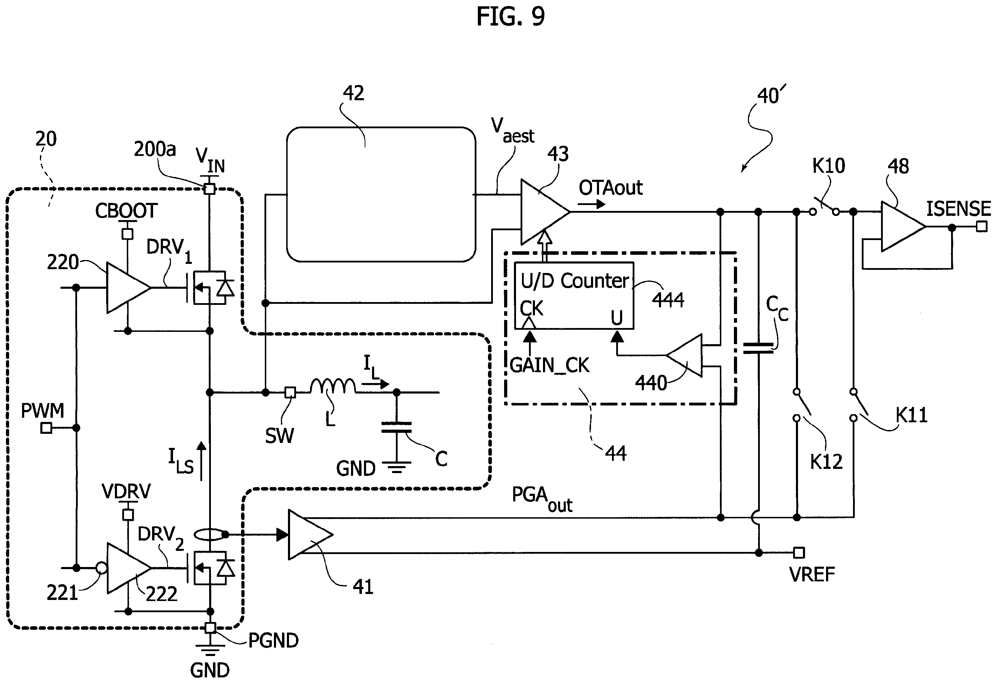

Figure 9 is a diagram exemplary of a way to implement the updating of the gain of the circuit block 44 using the principles exemplified in Figure 8.

In a circuit 40' as exemplified in Figure 9:

the first sensing amplifier 41 comprises a programmable gain amplifier, PGA, configured to output a voltage PGAout indicative of the current flowing in the second switch Q2 during the second time interval $LS_{ON}$;
the output voltage estimator circuit block 42 is coupled to a (e.g., transconductance) amplifier 43 that provides a current output signal OTAout.

For instance, the inductance estimator circuit block 44 comprises:

a comparator circuit 440 coupled to the circuit block 43 and to the first sensing circuit 41, the comparator configured to output a first (e.g., "1" or "true"), resp. second (e.g., "0" or "false"), logic value in response to the measured current $I_{LS}$ received from the first sensing circuit 41, and
a digital counter 444 coupled to the comparator 440 and configured to count, at a clock signal edge GAIN_CK, incrementally or decrementally based on the logic value U received from the comparator 440.

For instance, the digital counter 444 outputs a signal gm_control, e.g., comprising 9 bits and whose values can range [0, 511] and configured to vary the gain of the OTA 43 in a range, e.g. [0, 1.31 µA/V].

As exemplified in Figure 9, the circuit 40' further comprises:

a first selector switch K10 interposed the output of the circuit block 43 and the input of the buffer 48 and configured to be made selectively conductive in response to a first switching signal K10 having a first logic value (e.g., "1" or "true");

a second selector switch K11 interposed the output of the current sensing amplifier circuit 41 and the input of the buffer 48 and configured to be made selectively conductive in response to a second switching signal K11 having a first logic value (e.g., "1" or "true"), and

a third selector switch K12 interposed the output of the circuit block 43 and the output of the current sensing amplifier circuit 41 and configured to be made selectively conductive in response to a third switching signal K12 having a first logic value (e.g., "1" or "true").

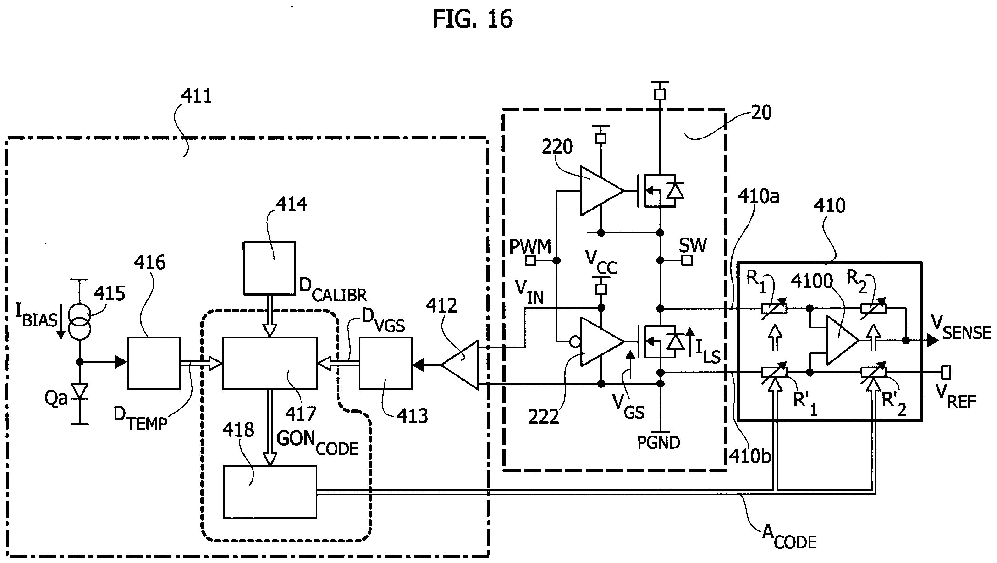

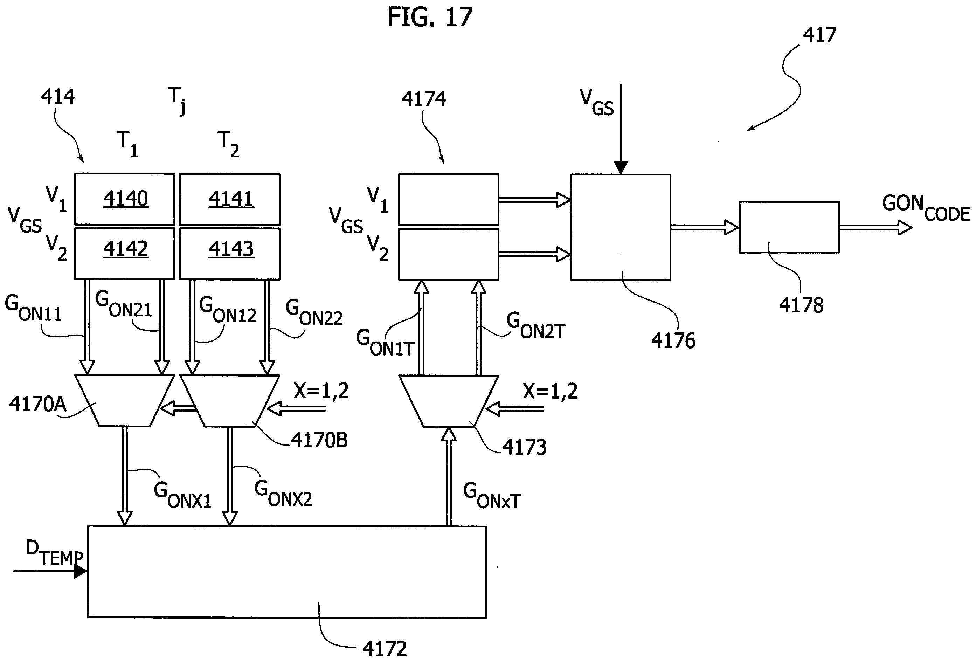

In the example illustrated in Figure 9 it may be possible to use a calibrated current sensing amplifier 41 as discussed in the following (mainly with reference to Figures 16 and 17). An improved accuracy in the measurement of the second switch current $I_{LS}$ may advantageously provide an improved accuracy in the current estimation cascade 42, 43, 44, 46, 48, as discussed in the following.

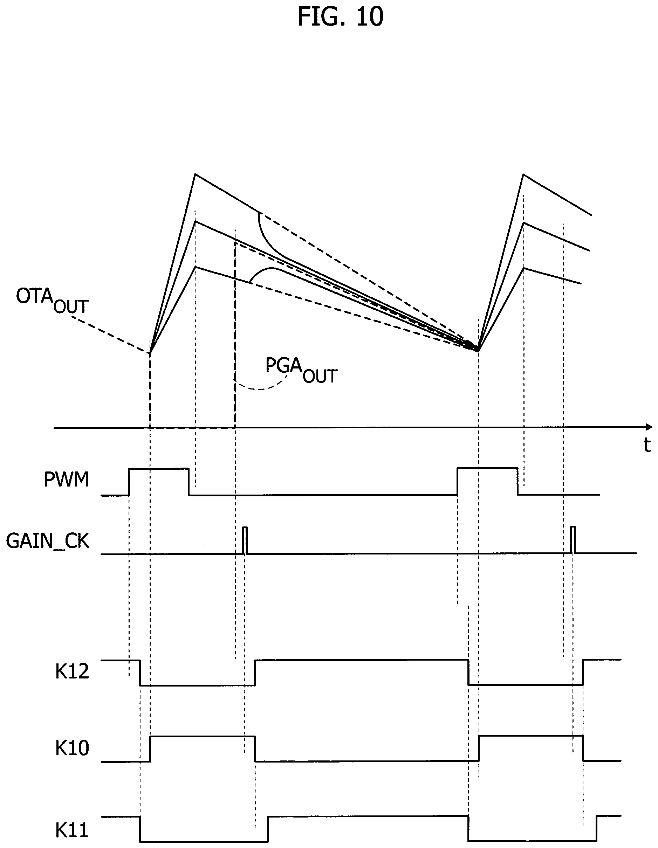

Figure 10 is a temporal diagram exemplary of signals which may be used in connection with the circuit exemplified in Figure 9.

As exemplified in Figure 10:

at the first (e.g., rising) edge of the drive signal PWM, the second selector switch K11 is turned off and also the third selector switch K12 is turned off, thereby coupling the amplifier 41 to the comparator 440 and decoupling it from the output buffer 48;

as soon as it is made available from the current sensing amplifier circuit 41, the value of the current sensing curve PGAout is sampled at the edge of clock signal GAIN_CK;

subsequently, the AGC loop is driven by the digital counter 444 to increase or decrease the gain of the OTA 43 based on the result of the comparison 440 among the sampled sensed current value PGAout and the output OTA signal OTAout.

For instance, after 100 cycles of iteration, the values of the signals PGAout and OTAout at the sample time instant GAIN_CK are about the same.

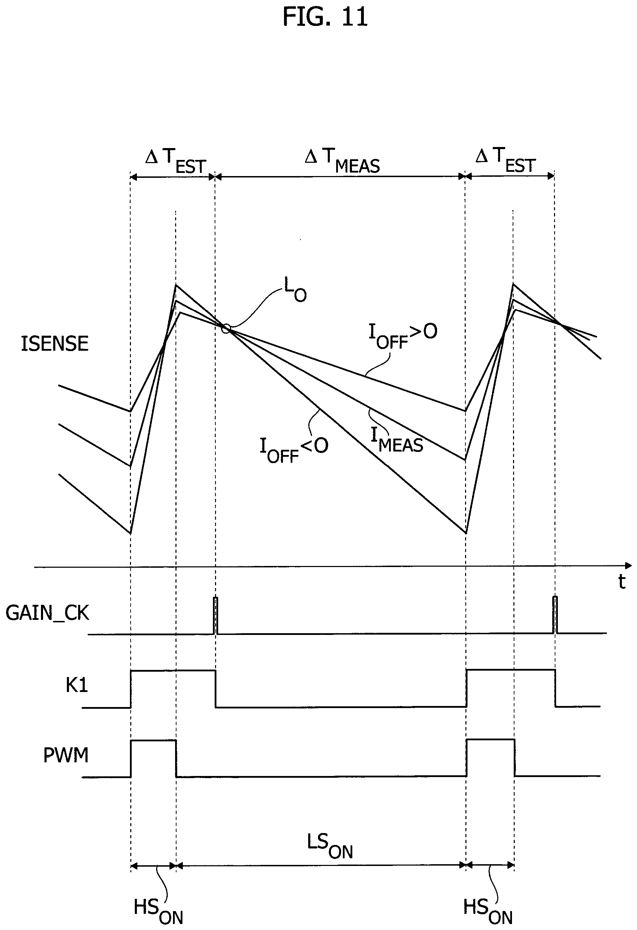

Figure 11 is a diagram of principles underlying one or more embodiments that consider non-linearities in the circuit exemplified in Figure 9.

As exemplified in Figure 9, in the presence of a negative or positive (unknown and unwanted) offset current, even if there is a very good match of the value L0 at the sampling clock edge, the evolution over time of the estimated current becomes appreciably different from the actual measured one $I_{MEAS}$.

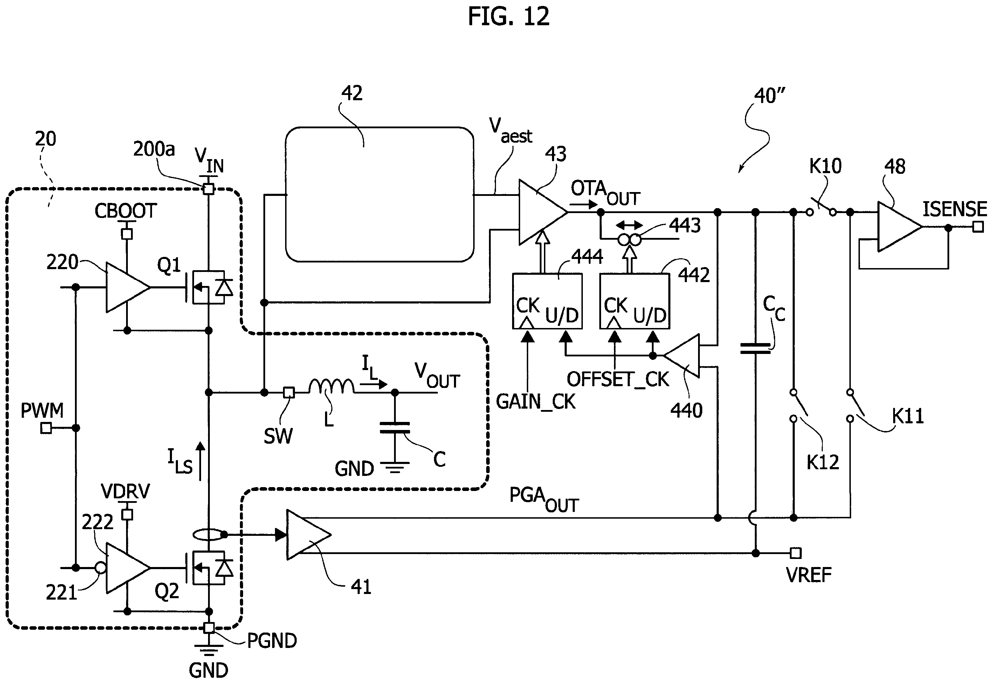

As exemplified in Figure 12, a circuit 40" that compensates for the current offset of circuit block 43 comprises a further digital counter 442 coupled to the comparator circuit 440 and to a programmable current generator 443 coupled to the output of the OTA amplifier 43, the programmable current generator 443 configured to generate a current based on the digital count indicated by the further digital counter 442. For instance, the further digital counter 442 is configured to produce a multi-bit further digital counter signal, e.g., 10-bit signal whose values can vary in a range [-512, 511] in order to drive the current generator 443 to generate a current intensity in a range of, e.g., [-2.5µA, 2.5µA].

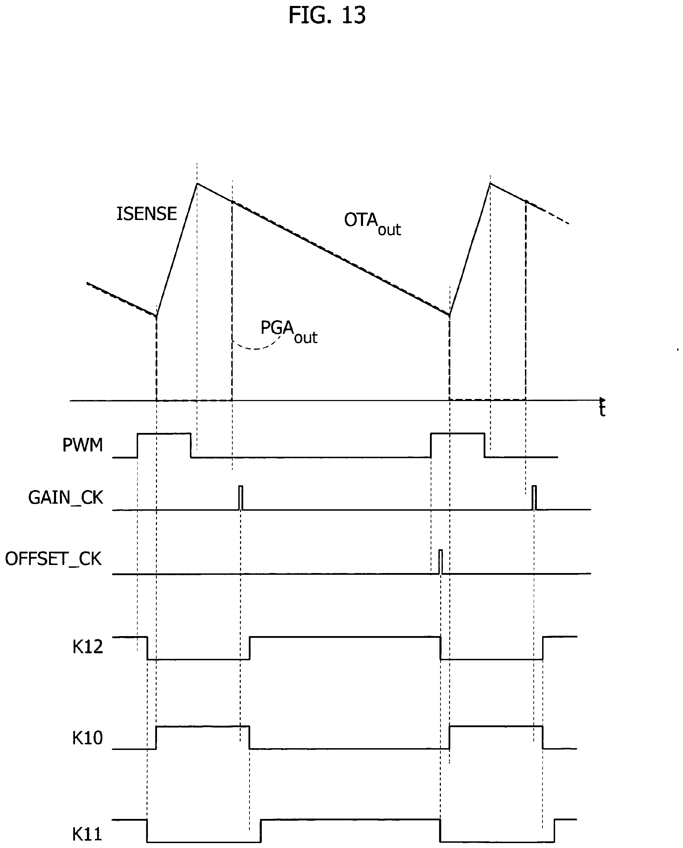

As exemplified in Figure 13, operation of the circuit 40" exemplified in Figure 12 is the same as that already illustrated in Figure 10 with the addition of a further clock signal OFFSET_CK that drives the further digital counter 442 to sample the value of the measured current signal PGAout and that of the estimated output value OTAout to perform a comparison therebetween and output a logic value that determines whether the digital counter increments or decrements the count, increasing or decreasing the amplitude of the programmable current generator 443 in a corresponding way.

In one or more embodiments the comparator 440 may comprise an auto- or self-calibrating comparator circuit (known per se) in order to take into account the introduction of further non-idealities. For instance, the circuit architectures 40, 40', 40" are configured to provide space to perform auto-calibration of the comparator circuit 440, in a manner per se known.

As exemplified in Figure 13, the further counter 442 may be activated a reduced number of times (e.g., once every four periods of the PWM signal) with respect to the first counter 444 since the variation over time of the offset that must be compensated can be considered slower than the gain variations tracked by the AGC loop.

As exemplified in Figure 13, it may be possible to skip asserting the third switch K12 to the first logic value once in a while (e.g., once every four cycles) in order to perform the offset compensation and trigger the further counter 442 correspondingly.

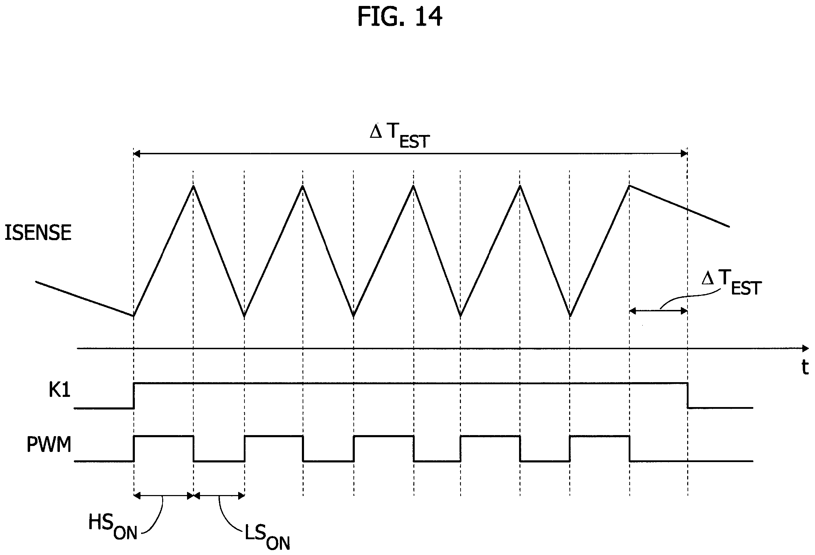

As exemplified in Figure 14, in case the second time interval $LS_{ON}$ lasts shorter than a fixed delay time (e.g, 200 ns where 1 ns = 1 nanosecond = $10^{-9}$ seconds) relative to the settling time of the amplifier circuit 41, the circuit 40, 40', 40" outputs an estimate of the current flowing through the inductive element L for up to a given number (e.g., ten) of PWM cycles; therefore, also in a transient condition in which the system reacts to fast load/line transients, and the time interval $LS_{ON}$ is relatively short, the estimated current ISENSE may remain valid for a finite number (e.g., ten) of PWM cycles.

As exemplified herein, ad advantage of the circuit 40, 40', 40" as per the present disclosure facilitates reconstructing an evolution over time of the current flowing in the inductive element L of the converter 20 even in case both switches Q1, Q2 of the half-bridge arrangement are turned off for a time interval much longer than the dead time.

As exemplified in Figures 9 and 12, the current sensing amplifier circuit block 41 is coupled to a reference voltage line VREF which is further coupled to the output of the OTA 43 via a capacitive element Cc, e.g., having a capacitance of about 10 pF (1 pF = 1 picoFarad = $10^{-12}$ Farad).

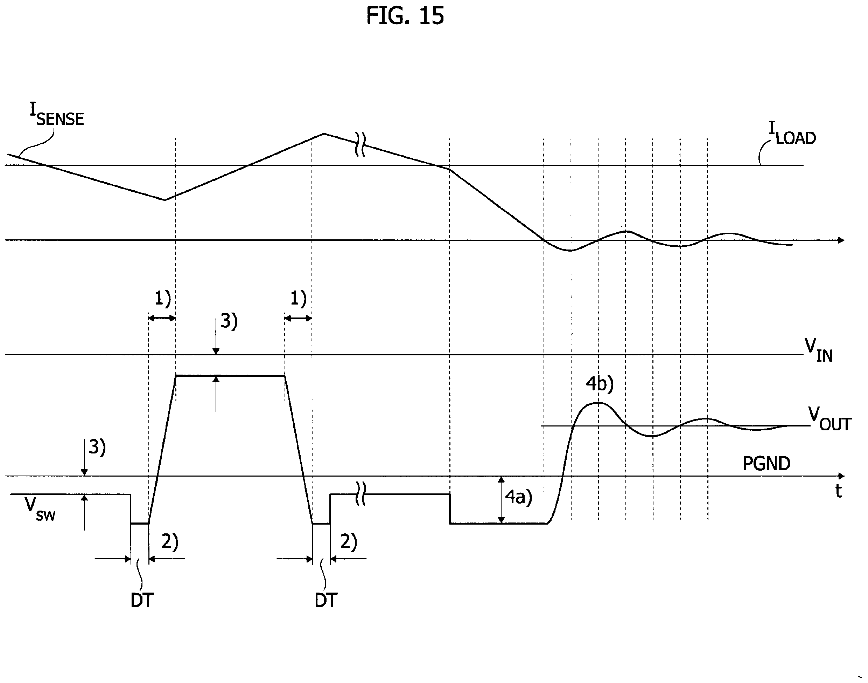

As exemplified in Figure 15, the sensing method comprises:

in response to both HS and LS being turned OFF, a (digital) counter is triggered to start counting;

during the time in which the counter is actively counting, the loop keeps following the load current value via the active OTA (transconductance) amplifier;

as soon as the counter reaches a pre-set value (e.g., 12 $\mu$s, where 1 $\mu$s = 1 microsecond = $10^{-6}$ seconds), a comparator detects whether the voltage at the switching node SW has changed sign (e.g., from negative to positive);

as a result of the comparator detecting a sign change for the voltage at the switching node, the voltage output of the amplifier 41 is forced to $V_{REF}$ (corresponding to a zero current signal at the ISENSE pin).

As exemplified in Figure 15, the circuit facilitates ensuring the accuracy of the reconstructed current even in presence of the following non-idealities:

1) Voltage slopes and delay at switching node SW;
2) Dead times DT of half-bridge switches Q1, Q2;
3) Voltage drops on half-bridge switches Q1, Q2;
4) Arbitrary voltage waveforms at switching node SW during high impedance state of half-bridge switches Q1, Q2, particularly:

4a) Recirculation on the body diode of switches Q1, Q2;
4b) Dumped oscillation of switching node voltage signal $V_{SW}$ at current turn off.

A method as exemplified in Figures 1 to 15 comprises:

coupling a high-side switch $Q_1$ between a high-side reference node $V_{IN}$ and a switching node SW,
coupling a low-side switch $Q_2$ between the switching node SW and a low-side reference node PGND.

For instance, the high-side switch comprises a high-side control terminal configured to receive a high-side control signal PWM, DRV1 as well as a current flow path therethrough between the high-side reference node and the switching node, the high-side switch being configured to be made conductive in response to the high-side control signal having a first logic value during a first time interval $HS_{ON}$.

For instance, the current flow path through the high-side switch provides a high-side current flow line $I_{HS}$ between the high-side reference node and the switching node.

For instance, the low-side switch comprises a low-side control terminal configured to receive a low-side control signal PWM, DRV2 as well as a current flow path therethrough between the switching node and the low-side reference node, the low-side switch being configured to be made conductive in response to the low-side control signal having said first logic value during a second time interval $LS_{ON}$.

For instance, the current flow path through the low-side switch provides a current flow line $I_{LS}$ between the switching node and the low-side reference node.

As exemplified in Figures 1 to 15, the method further comprises:

coupling an inductive element L to the switching node and to an output node Vout configured to be coupled to a load 30;
sensing the switching voltage $V_{SW}$ at the switching node, providing said sensed switching voltage to a filter circuit 42 configured to provide a filtered voltage Vo_est based on said sensed switching voltage, the filtered voltage indicative of the output voltage at said output node, and
based on a difference $V_{IND}$ between said filtered voltage and said sensed switching voltage, providing 43, 44, 46 to user circuitry 48 an output current signal IHS_est, ISENSE indicative of the intensity of a current through the inductive load during an estimation time $\Delta T_{EST}$ equal to or greater than said first time interval.

As exemplified in Figures 1 to 15, said filter circuit comprises a filter circuit having a cut-off frequency (e.g., about 16.0 kHz) based on an expected inductance value of the inductive element.

As exemplified in Figures 1 to 15 as well as Figures 15 and 16, the method further comprises:

receiving, via a measurement circuit 41, a current measurement signal PGAout indicative of a low-side current $I_{LS}$ flowing through said current flow path through said low-side switch;

via a transconductance amplifier, OTA circuit 43 having a variable gain, applying transconductance amplification to the difference of said filtered voltage and said sensed switching voltage, obtaining an amplified filtered current signal OTAout as a result.

For instance, the variable gain of said transconductance amplifier, OTA circuit is based on a stored digital code set via a digital counter circuit 444.

As exemplified in Figures 9 to 13, setting said digital code via said digital counter circuit comprises:

initiating said digital code of the digital counter to an initial digital code value;

at lapse GAIN_ck, K12 of said estimation time, performing a comparison 440 of said amplified filtered current signal and of said current measurement signal;

incrementing, respectively decrementing U/D, said digital code as a result of said current measurement signal exceeding, respectively failing to exceed, said amplified filtered current signal, and

varying the variable gain of said transconductance amplifier, OTA circuit based on said digital code incremented or decremented via said digital counter.

As exemplified in Figures 12 to 15, for instance:

said transconductance amplifier, OTA circuit has an offset current, and
the method further comprises:

generating an offset compensating current via a programmable current generator circuit 443 having a programmable current intensity, and
superimposing said offset compensating current to said amplified filtered current signal.

For instance, the programmable current intensity of said offset programmable current generator circuit is based on a stored further digital code set via a further digital counter circuit 442, as exemplified in Figure 12.

As exemplified in Figures 12 to 15, setting said further digital code via said further digital counter circuit comprises:

initiating said digital code of the further digital counter to an initial digital code value equal to zero;

right before the start OFFSET_CK of an estimation time interval $\Delta T_{EST}$, performing a comparison of said amplified filtered current signal and of said current measurement signal;

decrementing, respectively incrementing U/D, said further digital code as a result of said current measurement signal exceeding, respectively failing to exceed, said amplified filtered current signal, and

varying the programmable intensity of said offset compensating current generator circuit based on said further digital code incremented or decremented via said further digital counter.

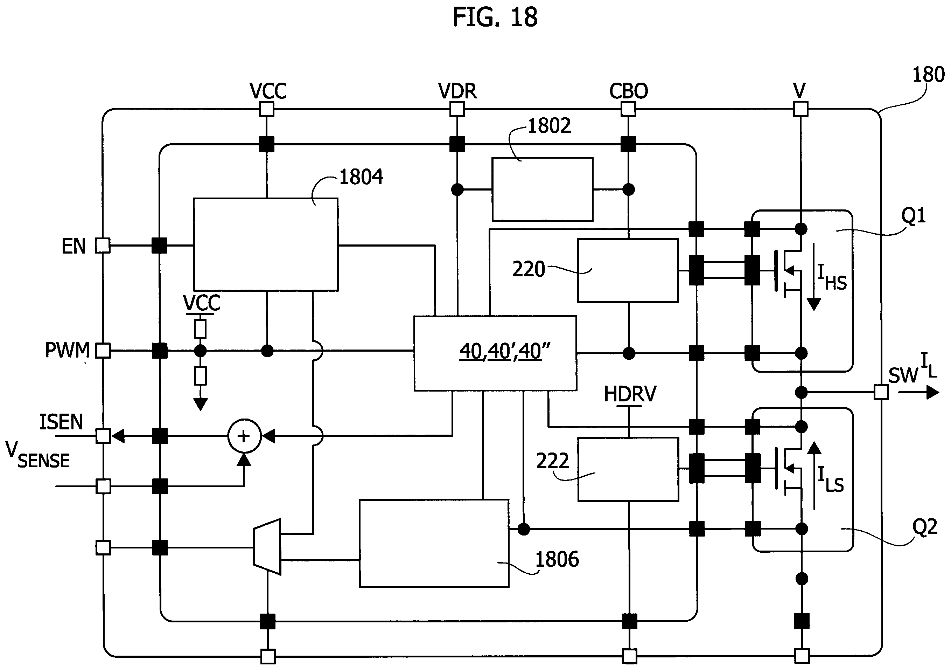

As exemplified in Figures 1 to 15, during said estimation time interval, the method comprises coupling K1; K10, K11, K12 an output of said OTA circuit to an output buffer 48 to provide the output current signal to user circuits (such as those exemplified in Figures 18 to 20),

while during the remaining time (outside of the estimation time interval), the method comprises coupling K1; K10, K11, K12 said measurement circuit 41 to the output buffer to provide the output current signal to user circuits (such as those exemplified in Figures 18 to 20).

As exemplified in Figures 1 to 15 as well as Figures 15 and 16, measuring a current measurement signal PGAout, Vsense comprises:

coupling one input node 410a of a further programmable gain OTA amplifier circuit 410 to said switching node and the other input node 410b of said OTA circuit to said low-side reference node, measuring a voltage drop across the low-side switch, and

applying said sensed voltage across a set of variable resistive elements R1, R2 configured to vary the gain of the further OTA circuit, providing said current measurement signal as a result.

For instance, the resistance of at least one variable resistive element in the set of variable resistive elements is set via an error compensating digital code Acode set via an error compensation circuit 411.

As exemplified in Figure 17, the error compensation circuit comprises:

a non-volatile memory circuit 414 having stored thereon parameter values Gon11, Gon12, Gon21, Gon22 of the low-side switch collected during manufacturing thereof at a plurality of temperature and operating/driving voltage values;
an operating voltage sensing circuit 412, 413 configured to sense an operating/driving voltage Vgs at the control terminal of the low-side switch during measurement 41 of the current measurement signal;
a temperature sensing circuit 415, 416 configured to sense an operating temperature Tj of the low-side switch during measurement of the current measurement signal;
a resistance calculation circuit 417, 418 configured to provide said error compensating digital code based on said stored low-side switch parameter values, said sensed operating/driving voltage and said sensed operating temperature.

As exemplified in Figures 16 and 17, the process parameters stored on the non-volatile memory comprise on-conductance values of the low-side switch collected by varying an operating temperature for a given operating voltage and by varying the operating/driving voltage at a given operating temperature.

As exemplified in Figures 16 and 17, the resistance calculation circuit comprises:

a first linear interpolation circuit 4172 configured to perform linear interpolation of sets of said on-conductance values collected at a given operating voltage and stored on the non-volatile memory, providing as a result a set of interpolated curves indicative of an evolution over temperature of the on-conductance of the low-side switch, the first linear interpolator circuit further configured to extract from the set of interpolated curves a set of on-conductance values Gon1T, Gon2T at the sensed temperature signal, and
a second linear interpolation circuit 4176 coupled to the first linear interpolator circuit to receive the extracted set of on-conductance values therefrom, the second linear interpolation circuit configured to perform linear interpolation of said extracted on-conductance values, providing as a result an interpolated curve indicative of an evolution over operating voltage of the on-conductance of the low-side switch, the second linear interpolator circuit further configured to extract from the interpolated curve an on-conductance values GonVT at the sensed operating voltage.

A circuit as exemplified in Figures 1 to 15 comprises:

a high-side switch coupled to a high-side reference node and to a switching node, in which the high-side switch comprises a high-side control terminal configured to receive a high-side control signal as well as a current flow path therethrough between the high-side reference node and the switching node, the high-side switch being configured to be made conductive in response to the high-side control signal having a first logic value during a first time interval, wherein the current flow path through the high-side switch provides a high-side current flow line between the high-side reference node and the switching node;
a low-side switch coupled to the switching node and to a low-side reference node, in which the low-side switch comprises a low-side control terminal configured to receive a low-side control signal as well as a current flow path therethrough between the switching node and the low-side reference node, the low-side switch being configured to be made conductive in response to the low-side control signal having said first logic value during a second time interval, wherein the current flow path through the low-side switch provides a current flow line between the switching node (SW) and the low-side reference node;
an inductive element coupled to the switching node and to an output node configured to be coupled to a load;
a filter circuit coupled to said switching node to sense a switching voltage therefrom, the filter circuit configured to provide a filtered voltage based on said sensed switching voltage, the filtered voltage indicative of the output voltage at said output node;
signal processing circuitry coupled to the filter circuit, the signal processing circuitry configured to, based on a difference between said filtered voltage and said sensed switching voltage, provide to user circuitry an output current signal IHS_est, ISENSE indicative of the intensity of a current through the inductive load during an estimation time $\Delta T_{EST}$ equal to or greater than said first time interval $HS_{ON}$ according to the method exemplified in Figures 1 to 15.

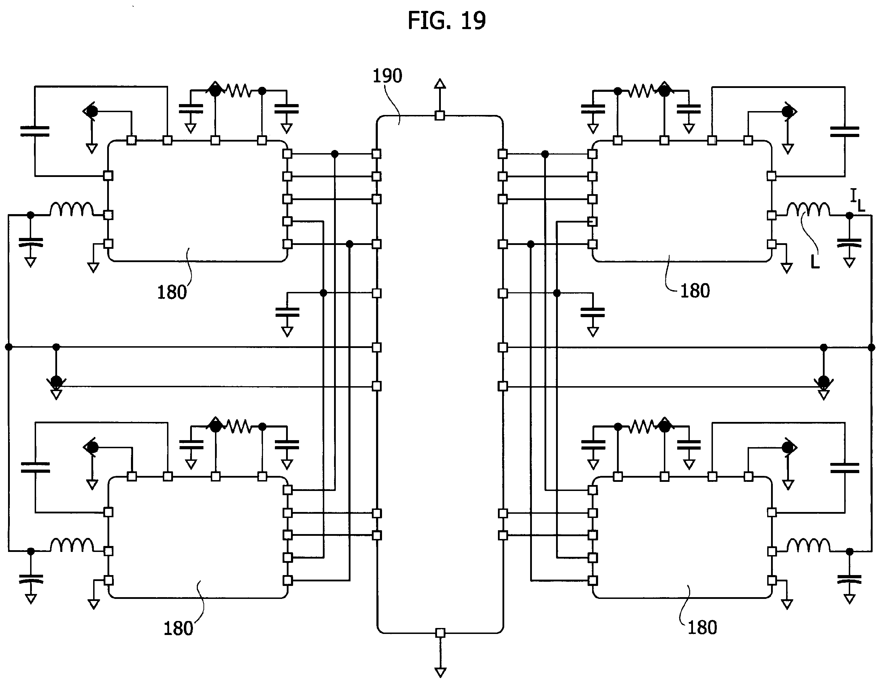

A switched converter device 180, 190 as exemplified in Figures 18 or 19 comprises a circuit 40, 40', 40" as exemplified in Figures 1 to 15 and a battery 10 configured to provide a voltage supply level to said reference node VI or a ground node PGND configured to provide a ground voltage level to said reference node. The switched converter device further comprises control circuitry configured to provide said control signal to the low-side and high-side switches of the circuit.

As exemplified in Figure 18, an electronic control unit, ECU, comprises:

at least one switched converter device 180 as exemplified in Figure 18 or at least one circuit 40, 40', 40" as exemplified in Figures 1 to 15;

a microcontroller 190 coupled to the at least one switched converter device or to the at least one circuit and configured to provide said control signal thereto, and

at least one load 30; 301, 302 configured to be coupled to the circuit to receive a regulated output voltage Vout therefrom.

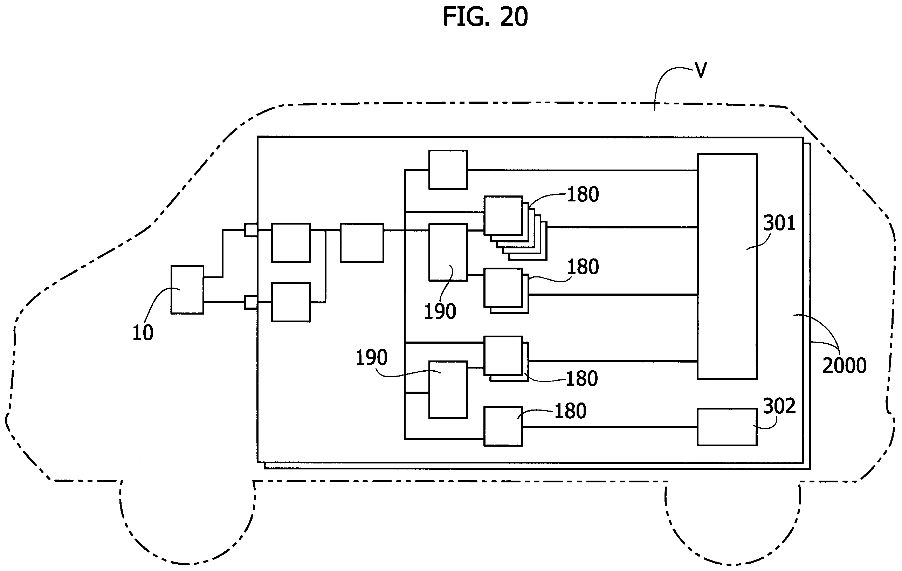

As exemplified in Figure 20, the ECU is mounted onboard a vehicle V such as a battery powered automotive vehicle.

As discussed in the foregoing, an accuracy of the estimation cascade 42, 43, 44, 46, 48 can be a function of the non-idealities of the components involved as well as of the accuracy and timing of the current sensing amplifier 41 in providing the signals for the measured current $I_{LS}$.

Figure 16 is an exemplary arrangement of a current sensing amplifier circuit block 41 which may be used in the circuit 40, 40', 40" as per the present disclosure or also in a conventional half-bridge circuit 20 to detect a current flowing through any one of the switches Q1, Q2.

As exemplified in Figure 16, a sensing circuit block 41 comprises:

a programmable gain amplifier, PGA 410 comprising a first PGA input node 410a coupled to the switching node SW and a second PGA input node 410b coupled to a terminal of a switch Q1, Q2 whose on-resistance Ron is under monitoring, for instance the second switch Q2; the PGA further comprises a first output node Vsense configured to provide a signal indicative of the current flowing across the switch Q2 and a second output node $V_{REF}$ configured to be coupled to a reference signal $V_{REF}$;

a compensation circuit block 411 coupled to switch under monitoring Q2 via the respective driver 222 and coupled to the PGA 410 to provide thereto compensation of non-idealities, as discussed in the following.

As appreciable to those of skill in the art, a gain value PGAgain of the PGA circuit 410 can be expressed as:

$$PGA_{GAIN} = \frac{R_2}{R_1} = \frac{R_2'}{R_1'}$$

As exemplified in Figure 16, the sense voltage signal Vsense is based on a reference voltage VREF and on a known expression, for instance:

$$V_{SENSE} = V_{REF} + 5mV/A \cdot I_{LS}$$

As the sense signal is also a function of the on-resistance Ron of the switch Q2 and the current flowing through the switch Q2. Therefore, the expression above can be rewritten as:

$$V_{SENSE} = V_{REF} + \frac{5mV}{A} \cdot I_{LS} = V_{REF} + R_{ON} \, I_{LS} \, PGA_{GAIN}$$

which yields

$$PGA_{GAIN} = \frac{R_2}{R_1} = \frac{5mV/A}{R_{ON}} = G_{ON} \, 5mV/A$$

As exemplified in Figure 16, the compensation circuitry 411 is configured to modify variable resistances of resistive elements $R_1$, $R_2$ in such a way that the above equation is respected throughout PVT variations of power MOS $R_{ON}$.

Specifically, it may be possible to vary the direct gain by varying a first resistive element R1 or the inverse gain by varying a second resistive element R2 of the PGA circuit 410.

As exemplified in Figure 16, the PGA circuit 410 comprises a differential amplifier 4100 having either a set of variable resistive elements *R1, R2* coupled to a first input node and output node to control a direct gain of the PGA circuit 410 or a second set of variable resistive elements *R1', R2'* coupled to a second input node and to the output node to control an inverse gain of PGA circuit 410, as discussed in the following.

As exemplified in Figure 16, the compensation circuit block 411 comprises:

a differential amplifier 412 comprising a first input node 412a and a second input node 412b coupled across the driver 222 of the second switch Q2 to detect a drive (e.g., gate) signal DRV2 thereof;

a first analog-to-digital converter, ADC circuit 413 coupled to an output node of the differential amplifier 412, the first ADC circuit 413 configured to output a digital signal $D_{VGS}$ indicative of the "real-time" value of an on-resistance $R_{ON}$ of the second switch Q2 at the operative temperature and supply voltage VCC;

a data storage circuit 414, such as a non-volatile memory, configured to store calibration data Dcalibr for correcting the Ron measurement, as discussed in the following; for instance, the data storage circuit 414 stores data output from the production line after the assembly of the switch Q2 together with its driver (in order to store data related to system-in-package, SiP non-idealities);

a programmable current generator 415 coupled to a diode Qa referred to ground, and

a second ADC circuit 416 coupled to the programmable current generator 415 and configured to apply analog-to-digital conversion thereto, providing a second digital current signal Dtemp indicative of the temperature of the switch Q2;

a linear interpolator 417 coupled to the first ADC circuit 413 to receive the first digital signal Dvgs therefrom, coupled to the data storage circuit 414 to receive the calibration signal Dcalibr therefrom and coupled to the second ADC circuit 416 to receive the second digital signal Dtemp therefrom, the linear interpolator 417 configured to provide a gain code GONcode based on the digital signals Dvgs, Dtemp and Dcalibr received, as discussed in the following with reference to Figure 17, and

a digital controller circuit 418 coupled to the linear interpolator 417 to receive the gain digital code GONcode therefrom and configured to provide the variation of the value of the resistance R1, R2 of the PGA amplifier 410 based on the received gain digital code GONcode.

As exemplified in Figure 16, the method of compensating the non-idealities of the PGA circuit 410 comprises:

receiving calibration data Dcalibr from the data storage circuit 414, the calibration data indicative of the manufacturing process of the SiP comprising the switch Q2;

receiving the first digital signal Dvgs from the first ADC circuit 412, the first digital signal Dvgs being indicative of calibration data collected from the manufacturing process of the switch Q2;

receiving the second digital signal Dtemp from the second ADC circuit 416, the second digital signal Dtemp being indicative of a temperature of operation of the switch Q2;

performing linear interpolation of the received signals Dcalibr, Dtemp, Dvgs, providing as a result a digital conductance value GONcode based on an on-conductance, that is the inverse of the on-resistance Ron, of the switch Q2 at the "real time" operating/driving voltage Vgs and temperature T;

generating a digital control code Acode (e.g, 10bit digital code) based on the digital conductance value GONcode and varying the direct gain resistances R1, R2 or the inverse gain resistances R1', R2' (in a manner per se known) in order to vary the gain of the PGA circuit 410 until it reaches a target value, which may be expressed as $PGA_{GAIN}=G_{ON}$ 5m V/A.

For instance, the control circuit block 418 may comprise a multiplier circuit and the digital control code Acode may be the result of the multiplication of the digital conductance value GONcode and the first digital signal Dvgs provided by the first ADC circuit 413, thereby mapping the conductance value to contro values of the resistive elements R1, R2 of the PGA 410.

As appreciable to those of skill in the art, a conductance Gon equal to an inverse on-resistance Ron of a (e.g., MOSFET) switch Q2 can be expressed as:

$$G_{ON}=\frac{1}{R_{ON}}=\frac{I_D}{V_{DS}}=\mu C_{ox}\frac{W}{L}(V_{GS}-V_T)$$

where

VGS is the gate-source operating/driving voltage;

VT is the MOSFET threshold voltage,

W is the width of the MOSFET channel,

L is the length of the MOSFET channel,

Cox is the gate oxide capacitance per area unit;

$\mu$ is the mobility parameter of the carriers forming the inversion channel of the MOSFET.

Inventors have noted that it is advantageous to exploit the linear relation between conductance Gon and temperature T as well as operating voltage Vgs.

Figure 17 is a diagram exemplary of a linear interpolator circuit 170 which may be used in block 4170 of the digital controller 417 exemplified in Figure 16.

For the sake of simplicity, one or more embodiments of the interpolator are discussed mainly with reference to an exemplary case of a linear interpolator based on two temperature values, being otherwise understood that such a number of temperature values is purely exemplary and in no way limiting. One or more embodiments may employ an N-temperatures interpolator with N potentially equal to any integer number equal to or greater than two.

As exemplified in Figure 17, the data storage circuit block 414 comprises at least four data storage cells, for instance:

a first data storage cell 4140 configured to store a first manufacturing/assembly process value, e.g., a first conductance value Gon11 at a first operating voltage V1 at a first temperature T1, e.g., $G_{ON11}=G_{ON}$ @ $V_1$, $T_1$;

a second data storage cell 4141 configured to store a second manufacturing process value, e.g., a second conductance value Gon12 at first operating voltage V1 and a second temperature T2, e.g., $G_{ON12}=G_{ON}$ @ $V_1$, $T_2$;

a third data storage cell 4142 configured to store a third manufacturing process value, e.g., a third conductance value Gon21 at a second operating voltage V2 and at the first temperature T1, e.g., $G_{ON21}=G_{ON}$ @ $V_2$, $T_1$;

a fourth data storage cell 4143 configured to store a fourth manufacturing process value, e.g., a fourth conductance value Gon22 at the second operating voltage V2 and at the second temperature T2, e.g., $G_{ON22}=G_{ON}$ @ $V_2$, $T_2$.

As exemplified in Figure 17, the linear interpolator 417 comprises:

a first multiplexer circuit 4170A coupled to the first 4140 and third 4142 data storage cells of the NVM circuit 414, the first multiplexer circuit 4170A configured to select, based on a selection signal X, one signal Gonx1 among the first Gon11 or third Gon21 process parameters stored in the respective data storage cells 4140, 4142 of the NVM circuit 414;

a second multiplexer circuit 4170B coupled to the second 4141 and fourth 4143 data storage cells of the NVM circuit 414, the second multiplexer circuit 4170B configured to select, based on the selection signal X, one signal Gonx2 among the second Gon12 or fourth Gon22 process parameters stored in the respective data storage cells 4140, 4142 of the NVM circuit 414;

a first linear interpolator circuit 4172 configured to interpolate a curve between the signals Gonx1, Gonx2 selected by the multiplexers 4170A, 4170B, the interpolated curve being indicative of an evolution over temperatures T1 and T2 of the process parameter Gon of the switch Q2.

As exemplified in Figure 17, the first linear interpolator circuit 4172 is further configured to receive the digital temperature code Dtemp from the second ADC circuit 416, thereby receiving data related to the real time operating temperature Tj of the switch Q2.

As exemplified, based on the received digital temperature code Dtemp and on each of the interpolated evolution over temperature of the selected process parameters Gonx1, Gonx2 of the switch Q2, the first linear interpolator 4172 is configured to provide a set of estimates Gon1T, Gon2T of the process parameter at the real time temperature Tj and to store them in respective memory cells of a (e.g., RAM) temporary memory circuit 4174. For instance, the set of estimates Gon1T, Gon2T may be sequentially stored in the temporary memory 4174 via a further multiplexer 4173 driven by the selector signal X, where the further multiplexer 4173 selects a respective cell of the RAM 4174 as the respective data value GonxT is provided by the linear interpolator for each value of the selector signal X.

As exemplified in Figure 17, the linear interpolator 417 further comprises a second linear interpolator 4176 coupled to the temporary memory 4174 to receive the values of process parameters Gon1T, Gon2T at the real time temperature Tj of the switch Q2.

As exemplified in Figure 17, the second linear interpolator 4176 is configured to:

perform a linear interpolation of the data stored in the temporary memory 4174, obtaining as a result a curve indicative of an evolution over operating/driving voltage values Vgs of the process parameter values, and

based on the obtained curve, providing 4178 the digital parameter code GONcode as the value GonVT of the process parameter Gon at the real time temperature Tj and real time operating/driving voltage Vgs of the switch Q2 extracted from the obtained curve.

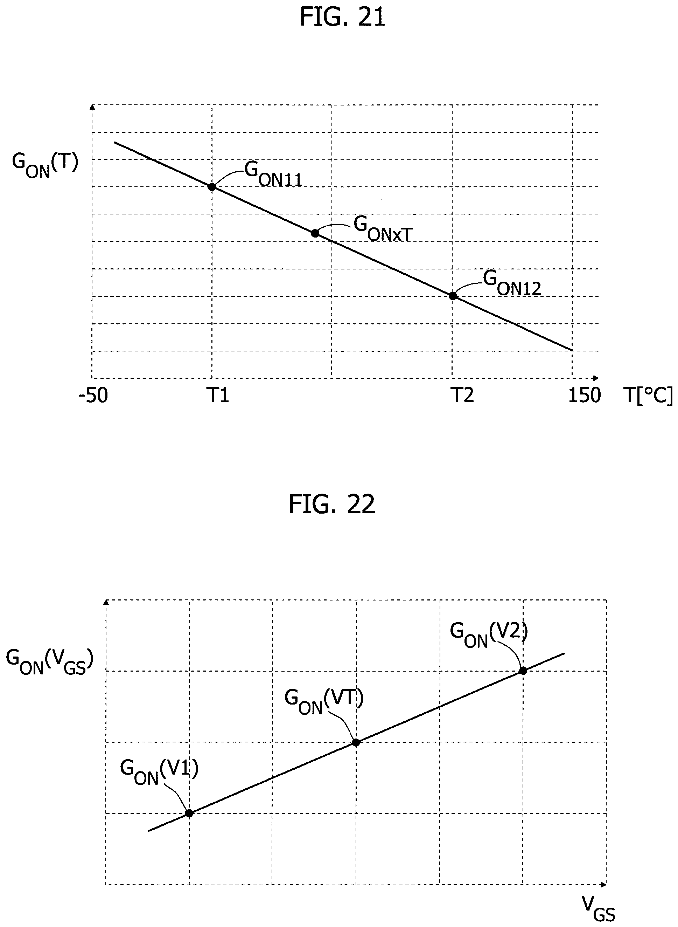

Figure 21 is a diagram exemplary of an extrapolated curve of the evolution of on-conductance Gon versus temperature T that may be provided by the first linear interpolator circuit block 4172.

Figure 22 is a diagram exemplary of an extrapolated curve of the evolution of on-conductance Gon versus operating/driving voltage Vgs that may be provided by the second linear interpolator circuit block 4176.

As exemplified in Figures 16 and 17, a method comprises measuring 41 a current measurement signal PGAout through a low-side switch $Q_2$ coupled between a switching node SW and a low-side reference node PGND, in which the low-side switch comprises a low-side control terminal configured to receive a low-side control signal as well as a current flow path therethrough between the switching node and the low-side reference node, the low-side switch being configured to be made conductive in response to the low-side control signal having said first logic value during a second time interval, wherein the current flow path through the low-side switch provides a current flow line between the switching node and the low-side reference node.

As exemplified in Figures 16 and 17, the method comprises:

coupling one input node of a further programmable gain OTA amplifier circuit to said switching node and the other input node of said OTA circuit to said low-side reference node, measuring a voltage drop across the low-side switch; applying said sensed voltage across a set of variable resistive elements configured to vary the gain of the further OTA circuit, providing said current measurement signal as a result.

For instance, the resistance of at least one variable resistive element in the set of variable resistive elements is set via an error compensating digital code provided via an error compensation circuit.

As exemplified in Figures 16 and 17, the error compensation circuit comprises:

a Non-Volatile Memory (NVM) circuit having stored thereon parameter values of the low-side switch collected during manufacturing and/or system-in-package assembly thereof at a plurality of temperature and operating voltage values; an operating voltage sensing circuit configured to sense an operating voltage at the control terminal of the low-side switch during measurement of the current measurement signal; a temperature sensing circuit configured to sense an operating temperature of the low-side switch during measurement of the current measurement signal, and a resistance calculation circuit configured to provide said error compensating digital code based on said stored low-side switch parameter values, said sensed operating voltage and said sensed operating temperature.

As exemplified in Figures 16 and 17, the process parameters stored on the non-volatile memory comprise a set of on-conductance values of the low-side switch collected by varying an operating temperature for a given operating voltage and by varying the operating voltage at a given operating temperature.

As exemplified in Figures 16 and 17, the resistance calculation circuit comprises:

a first linear interpolation circuit 4172 configured to perform linear interpolation of sets of said on-conductance values collected at a given operating voltage and stored on the non-volatile memory, providing as a result a set of interpolated curves indicative of an evolution over temperature of the on-conductance of the low-side switch, the first linear interpolator circuit further configured to extract from the set of interpolated curves a set of on-conductance values at the sensed temperature signal, and a second linear interpolation circuit coupled to the first linear interpolator circuit to receive the extracted set of on-conductance values therefrom, the second linear interpolation circuit configured to perform linear interpolation of said extracted on-conductance values, providing as a result an interpolated curve indicative of an evolution over operating voltage of the on-conductance of the low-side switch, the second linear interpolator circuit further configured to extract from the interpolated curve an on-conductance values at the sensed operating voltage.

As exemplified in Figure 18, the current sensing circuit 40, 40', 40" as per the present disclosure may be part of an integrated circuit 180 comprising the half bridge arrangement of switches Q1, Q2, their drivers 220, 221, 222 and other circuitry (per se known) such as bootstrap circuitry 1802, control logic and protection circuitry 1804 and thermal sensing circuitry 1806.

As exemplified in Figure 19, a plurality of integrated circuits 180 as that exemplified in Figure 18 may be coupled to a signal processing core, such as a microcontroller unit 190 and to a plurality of respective inductive loads L.

As exemplified in Figure 20, a plurality of controller units 190 may be coupled to a plurality of power stages 180 according to the present disclosure and may be embedded on one or more printed circuit boards, PCB 2000 coupled to a battery 10 and equipped on-board a vehicle V, such as an autonomous driving car or electric vehicle.

As exemplified in Figure 20, the power stages 180 may be used to power loads 301, 302 such as a general purpose processing unit or a data storage unit, known per se.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

**Claims**

1. A method, comprising:

   coupling a high-side switch ($Q_1$) between a high-side reference node ($V_{IN}$) and a switching node (SW),
   coupling a low-side switch ($Q_2$) between the switching node (SW) and a low-side reference node (PGND), wherein:

   the high-side switch ($Q_1$) comprises a high-side control terminal configured to receive a high-side control signal (PWM, DRV1) as well as a current flow path therethrough between the high-side reference node ($V_{IN}$) and the switching node (SW), the high-side switch ($Q_1$) being configured to be made conductive in response to the high-side control signal (DRV1) having a first logic value during a first time interval ($HS_{ON}$), wherein the current flow path through the high-side switch ($Q_1$) provides a high-side current flow line ($I_{HS}$) between the high-side reference node ($V_{IN}$) and the switching node (SW),
   the low-side switch ($Q_2$) comprises a low-side control terminal configured to receive a low-side control signal (PWM, DRV2) as well as a current flow path therethrough between the switching node (SW) and the low-side reference node (PGND), the low-side switch ($Q_2$) being configured to be made conductive in response to the low-side control signal (DRV2) having said first logic value during a second time interval ($LS_{ON}$), wherein the current flow path through the low-side switch ($Q_2$) provides a current flow line ($I_{LS}$) between the switching node (SW) and the low-side reference node (PGND);

   the method further comprising:

   coupling an inductive element (L) to the switching node (SW) and to an output node (Vout) configured to be coupled to a load (30);
   sensing the switching voltage ($V_{SW}$) at the switching node (SW), providing said sensed switching voltage ($V_{SW}$) to a filter circuit (42) configured to provide a filtered voltage (Vo_est) based on said sensed switching voltage ($V_{SW}$), the filtered voltage (Vo_est) indicative of the output voltage at said output node (Vout), and based on a difference ($V_{IND}$) between said filtered voltage (Vo_est) and said sensed switching voltage ($V_{SW}$), providing (43, 44, 46) to user circuitry (48) an output current signal (IHS_est, ISENSE) indicative of the intensity of a current through the inductive load (L) during an estimation time ($\Delta T_{EST}$) equal to or greater than said first time interval ($HS_{ON}$).

2. The method of claim 1, wherein said filter circuit (42) comprises a filter circuit having a cut-off frequency based on an expected inductance value of the inductive element (L), preferably a cut-off frequency about 16.0 kHz.

3. The method of claim 1 or claim 2, comprising:

   receiving, via a measurement circuit (41), a current measurement signal (PGAout) indicative of a low-side current ($I_{LS}$) flowing through said current flow path through said low-side switch ($Q_2$), and
   via a transconductance amplifier, OTA circuit (43) having a variable gain, applying transconductance amplification to the difference ($V_{IND}$) of said filtered voltage (Vo_est) and said sensed switching voltage ($V_{SW}$), obtaining an amplified filtered current signal (OTAout) as a result,
   wherein the variable gain of said transconductance amplifier, OTA circuit (43) is based on a stored digital code set via a digital counter circuit (444).

4. The method of claim 3, wherein setting said digital code via said digital counter circuit (444) comprises:

initiating said digital code of the digital counter (444) to an initial digital code value;
at lapse (GAIN ck, K12) of said estimation time ($\Delta T_{EST}$), performing a comparison (440) of said amplified filtered current signal (OTAout) and of said current measurement signal (PGAout);
incrementing, respectively decrementing (U/D), said digital code as a result of said current measurement signal (PGAout) exceeding, respectively failing to exceed, said amplified filtered current signal (OTAout), and
varying the variable gain of said transconductance amplifier, OTA circuit (43) based on said digital code incremented or decremented via said digital counter (444).

5. The method of claim 3 or claim 4, wherein:

said transconductance amplifier, OTA circuit (43) has an offset current, and
the method further comprises:

generating an offset compensating current via a programmable current generator circuit (443) having a programmable current intensity, and
superimposing said offset compensating current (443) to said amplified filtered current signal (OTAout),

wherein the programmable current intensity of said offset programmable current generator circuit (443) is based on a stored further digital code set via a further digital counter circuit (442).

6. The method of claim 5, wherein setting said further digital code via said further digital counter circuit (442) comprises:

initiating said digital code of the further digital counter (442) to an initial digital code value equal to zero;
right before the start (OFFSET_CK) of an estimation time interval ($\Delta T_{EST}$), performing a comparison (440) of said amplified filtered current signal (OTAout) and of said current measurement signal (PGAout);
decrementing, respectively incrementing (U/D), said further digital code as a result of said current measurement signal (PGAout) exceeding, respectively failing to exceed, said amplified filtered current signal (OTAout), and
varying the programmable intensity of said offset compensating current generator circuit (443) based on said further digital code incremented or decremented via said further digital counter (442).

7. The method of claim 3, comprising:

during said estimation time interval ($\Delta T_{EST}$), coupling (K1; K10, K11, K12) an output of said OTA circuit (43) to an output buffer (48) to provide the output current signal (ISENSE) to user circuits, and
during the remaining time, coupling (K1; K10, K11, K12) said measurement circuit (41) to the output buffer (48) to provide the output current signal (ISENSE) to user circuits.

8. The method of claim 3, wherein measuring (41) a current measurement signal (PGAout, Vsense) comprises:

coupling one input node (410a) of a further programmable gain OTA amplifier circuit (410) to said switching node (SW) and the other input node (410b) of said OTA circuit (410) to said low-side reference node (PGND), measuring a voltage drop across the low-side switch (Q2);
applying said sensed voltage across a set of variable resistive elements (R1, R2) configured to vary the gain of the further OTA circuit (410), providing said current measurement signal (PGAout, Vsense) as a result;
wherein:

the resistance of at least one variable resistive element in the set of variable resistive elements (R1, R2) is set via an error compensating digital code (Acode) provided via an error compensation circuit (411),
the error compensation circuit (411) comprises:

a non-volatile memory circuit (414) having stored thereon parameter values (Gon11, Gon12, Gon21, Gon22) of the low-side switch (Q2) collected during manufacturing thereof at a plurality of temperature and operating voltage values;
an operating voltage sensing circuit (412, 413) configured to sense an operating voltage (Vgs) at the control terminal of the low-side switch (Q2) during measurement (41) of the current measurement signal (PGAout, Vsense);

a temperature sensing circuit (415, 416) configured to sense an operating temperature (Tj) of the low-side switch (Q2) during measurement (41) of the current measurement signal (PGAout, Vsense), and

a resistance calculation circuit (417, 418) configured to provide said error compensating digital code (Acode) based on said stored low-side switch parameter values (Gon11, Gon12, Gon21, Gon22), said sensed operating voltage (Vgs) and said sensed operating temperature (Tj).

9. The method of claim 8, wherein:

the process parameters stored on the non-volatile memory comprise on-conductance values of the low-side switch (Q2) collected by varying an operating temperature for a given operating voltage and by varying the operating voltage at a given operating temperature, and
the resistance calculation circuit (417, 418) comprises:

a first linear interpolation circuit (4172) configured to perform linear interpolation of sets of said on-conductance values collected at a given operating voltage and stored on the non-volatile memory (414), providing as a result a set of interpolated curves indicative of an evolution over temperature of the on-conductance of the low-side switch (Q2), the first linear interpolator circuit (4172) further configured to extract from the set of interpolated curves a set of on-conductance values (Gon1T, Gon2T) at the sensed temperature signal (Tj), and

a second linear interpolation circuit (4176) coupled to the first linear interpolator circuit (4172) to receive the extracted set of on-conductance values (Gon1T, Gon2T) therefrom, the second linear interpolation circuit (4174) configured to perform linear interpolation of said extracted on-conductance values, providing as a result an interpolated curve indicative of an evolution over operating voltage of the on-conductance of the low-side switch (Q2), the second linear interpolator circuit (4176) further configured to extract from the interpolated curve an on-conductance values (GonVT) at the sensed operating voltage (Vgs).

10. A circuit (40, 40', 40"), comprising:

a high-side switch ($Q_1$) coupled to a high-side reference node ($V_{IN}$) and to a switching node (SW);
a low-side switch ($Q_2$) coupled to the switching node (SW) and to a low-side reference node (PGND),
wherein:

the high-side switch ($Q_1$) comprises a high-side control terminal configured to receive a high-side control signal (PWM, DRV1) as well as a current flow path therethrough between the high-side reference node ($V_{IN}$) and the switching node (SW), the high-side switch ($Q_1$) being configured to be made conductive in response to the high-side control signal (DRV1) having a first logic value during a first time interval ($HS_{ON}$), wherein the current flow path through the high-side switch ($Q_1$) provides a high-side current flow line ($I_{HS}$) between the high-side reference node ($V_{IN}$) and the switching node (SW);
the low-side switch ($Q_2$) comprises a low-side control terminal configured to receive a low-side control signal (PWM, DRV2) as well as a current flow path therethrough between the switching node (SW) and the low-side reference node (PGND), the low-side switch ($Q_2$) being configured to be made conductive in response to the low-side control signal (DRV2) having said first logic value during a second time interval ($LS_{ON}$), wherein the current flow path through the low-side switch ($Q_2$) provides a current flow line ($I_{LS}$) between the switching node (SW) and the low-side reference node (PGND);
the circuit (40, 40', 40") further comprises:

an inductive element (L) coupled to the switching node (SW) and to an output node (Vout) configured to be coupled to a load (30);
a filter circuit (42) coupled to said switching node (SW) to sense a switching voltage ($V_{SW}$) therefrom, the filter circuit (42) configured to provide a filtered voltage (Vo_est) based on said sensed switching voltage ($V_{SW}$), the filtered voltage (Vo_est) indicative of the output voltage at said output node (Vout), and
signal processing circuitry (43, 44, 46) coupled to the filter circuit (42), the signal processing circuitry (43, 44, 46) configured to, based on a difference ($V_{IND}$) between said filtered voltage (Vo_est) and said sensed switching voltage ($V_{SW}$), provide to user circuitry (48) an output current signal (IHS_est, ISENSE) indicative of the intensity of a current through the inductive load (L) during an estimation time ($\Delta T_{EST}$) equal to or greater than said first time interval ($HS_{ON}$) according to the method of any one of claims 1 to 9.

11. A switched converter device (180, 190), comprising:

a circuit (40, 40', 40") according to claim 10;
a battery (10) configured to provide a voltage supply level to said reference node (VI, PGND) or a ground node configured to provide a ground voltage level to said reference node (VI, PGND), and
control circuitry configured to provide said control signal (PWM; DRV1, DRV2).

12. An electronic control unit, ECU, comprising:

at least one switched converter device (180) according to claim 11 or at least one circuit (40; 40'; 40") according to claim 10;
a microcontroller (190) coupled to the at least one switched converter device (180) or to the at least one circuit (40; 40'; 40") and configured to provide said control signal (PWM; DRV1, DRV2) thereto, and
at least one load (30; 301, 302) configured to be coupled to the circuit to receive a regulated output voltage (Vout) therefrom.

13. The electronic control unit, ECU according to claim 12, wherein the ECU is mounted onboard a vehicle (V), preferably a battery powered automotive vehicle.

14. A method of measuring (41) a current measurement signal (PGAout) through a low-side switch ($Q_2$) coupled between the switching node (SW) and a low-side reference node (PGND), wherein the low-side switch ($Q_2$) comprises a low-side control terminal configured to receive a low-side control signal (PWM, DRV2) as well as a current flow path therethrough between the switching node (SW) and the low-side reference node (PGND), the low-side switch ($Q_2$) being configured to be made conductive in response to the low-side control signal (DRV2) having said first logic value during a second time interval ($LS_{ON}$), wherein the current flow path through the low-side switch ($Q_2$) provides a current flow line ($I_{LS}$) between the switching node (SW) and the low-side reference node (PGND), the method comprising:

coupling one input node of a further programmable gain OTA amplifier circuit (410) to said switching node (SW) and the other input node of said OTA circuit (410) to said low-side reference node (PGND), measuring a voltage drop across the low-side switch (Q2);
applying said sensed voltage across a set of variable resistive elements (R1, R2) configured to vary the gain of the further OTA circuit (410), providing said current measurement signal (PGAout, Vsense) as a result,
wherein:

the resistance of at least one variable resistive element in the set of variable resistive elements (R1, R2) is set via an error compensating digital code (Acode) provided via an error compensation circuit (411);
the error compensation circuit (411) comprises:

a non-volatile memory circuit (414) having stored thereon parameter values (Gon11, Gon12, Gon21, Gon22) of the low-side switch (Q2) collected during manufacturing thereof at a plurality of temperature and operating voltage values;
an operating voltage sensing circuit (412, 413) configured to sense an operating voltage (Vgs) at the control terminal of the low-side switch (Q2) during measurement (41) of the current measurement signal (PGAout, Vsense);
a temperature sensing circuit (415, 416) configured to sense an operating temperature (Tj) of the low-side switch (Q2) during measurement (41) of the current measurement signal (PGAout, Vsense), and
a resistance calculation circuit (417, 418) configured to provide said error compensating digital code (Acode) based on said stored low-side switch parameter values (Gon11, Gon12, Gon21, Gon22), said sensed operating voltage (Vgs) and said sensed operating temperature (Tj).

15. The method of claim 14, wherein:

the process parameters stored on the non-volatile memory comprise on-conductance values of the low-side switch (Q2) collected by varying an operating temperature for a given operating voltage and by varying the operating voltage at a given operating temperature, and
the resistance calculation circuit (417, 418) comprises:

a first linear interpolation circuit (4172) configured to perform linear interpolation of sets of said on-conductance values collected at a given operating voltage and stored on the non-volatile memory (414), providing as a result a set of interpolated curves indicative of an evolution over temperature of the on-conductance of the low-side switch (Q2), the first linear interpolator circuit (4172) further configured to extract from the set of interpolated curves a set of on-conductance values (Gon1T, Gon2T) at the sensed temperature signal (Tj), and

a second linear interpolation circuit (4176) coupled to the first linear interpolator circuit (4172) to receive the extracted set of on-conductance values (Gon1T, Gon2T) therefrom, the second linear interpolation circuit (4174) configured to perform linear interpolation of said extracted on-conductance values, providing as a result an interpolated curve indicative of an evolution over operating voltage of the on-conductance of the low-side switch (Q2), the second linear interpolator circuit (4176) further configured to extract from the interpolated curve an on-conductance values (GonVT) at the sensed operating voltage (Vgs).

FIG. 1    FIG. 1

FIG. 2

EP 4 661 266 A1

# FIG. 3

FIG. 4

# FIG. 5

EP 4 661 266 A1

## FIG. 6

—ISENSE(Vout)   —ISENSE(Vo_est)

a)

1.00V

—•—Vo_est   ——  Vout

b)

1.0V

$I_{LOAD}$

## FIG. 7

—ISENSE(Vout)   —ISENSE(Vo_est)

a)

1.00V

——Vout   —•—Vo_est

b)

1.0V

# FIG. 8

FIG. 9

EP 4 661 266 A1

# FIG. 10

# FIG. 11

FIG. 12

## FIG. 13

# FIG. 14

EP 4 661 266 A1

# FIG. 15

EP 4 661 266 A1

FIG. 16

EP 4 661 266 A1

# FIG. 17

EP 4 661 266 A1

FIG. 18

## FIG. 19

FIG. 20

## FIG. 21

## FIG. 22

Europäisches
Patentamt

European
Patent Office

Office européen
des brevets

## EUROPEAN SEARCH REPORT

**Application Number**

EP 25 31 5186

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 063 146 B1 (LEE GILBERT S Z [US]) 28 August 2018 (2018-08-28) | 1-3, 10-12 | INV. H02M1/00 |
| A | * column 3, line 61 - line 67; figures 2, 3, 6a, 6b, 7a * <br> * column 4 - column 8 * | 4-9,14, 15 | H02M3/158 H02M3/157 |
| | ----- | | |
| X | US 2021/159788 A1 (KASTURI PRASAN [US]) 27 May 2021 (2021-05-27) | 1-3, 10-13 | |
| A | * paragraph [0026] - paragraph [0062]; figures 1-4a * | 4-9,14, 15 | |
| | ----- | | |
| A | US 2015/349636 A1 (BODANO EMANUELE [AT] ET AL) 3 December 2015 (2015-12-03) * paragraph [0036] - paragraph [0055]; claim 7; figures 1-3, 4a, 4b, 7, 9 * | 1-15 | |
| | ----- | | |

**TECHNICAL FIELDS SEARCHED (IPC)**

H02M

The present search report has been drawn up for all claims

| Place of search | Date of completion of the search | Examiner |
|---|---|---|
| The Hague | 27 July 2025 | Zeljkovic, Sandra |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P4C01)

## ANNEX TO THE EUROPEAN SEARCH REPORT
## ON EUROPEAN PATENT APPLICATION NO.

EP 25 31 5186

This annex lists the patent family members relating to the patent documents cited in the above-mentioned European search report.
The members are as contained in the European Patent Office EDP file on
The European Patent Office is in no way liable for these particulars which are merely given for the purpose of information.

27-07-2025

| Patent document cited in search report | | Publication date | Patent family member(s) | | Publication date |
|---|---|---|---|---|---|
| US 10063146 | B1 | 28-08-2018 | CN | 108712059 A | 26-10-2018 |
| | | | TW | 201838304 A | 16-10-2018 |
| | | | US | 10063146 B1 | 28-08-2018 |
| US 2021159788 | A1 | 27-05-2021 | CN | 112858753 A | 28-05-2021 |
| | | | EP | 3828555 A1 | 02-06-2021 |
| | | | US | 2021159788 A1 | 27-05-2021 |
| US 2015349636 | A1 | 03-12-2015 | CN | 105305818 A | 03-02-2016 |
| | | | DE | 102015108822 A1 | 03-12-2015 |
| | | | US | 2015349636 A1 | 03-12-2015 |
| | | | US | 2017149334 A1 | 25-05-2017 |

EPO FORM P0459

For more details about this annex : see Official Journal of the European Patent Office, No. 12/82

**EP 4 661 266 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100060257 A1
- US 20210159788 A1